# EUROPEAN PATENT APPLICATION

(11) **EP 4 727 295 A1**
(43) Date of publication of application: **15.04.2026**
(21) Application number: 25203428.5
(22) Date of filing: 19.09.2025
(51) Int. Cl.: H10D 86/40, H10D 86/60, H10K 59/121, H10D 30/67

(54) **DISPLAY APPARATUS**

(30) Priority: 10.10.2024 KR 20240137438
(71) Applicant: Samsung Display Co., Ltd., Yongin-si, Gyeonggi-do 17113 (KR)
(72) Inventor: LEE, Dong-Hoon, 17113 Yongin-si (KR); KOO, Bon-Yong, 17113 Yongin-si (KR); KIM, Yeonhong, 17113 Yongin-si (KR); LEE, Yujin, 17113 Yongin-si (KR); HEO, Mindo, 17113 Yongin-si (KR)
(74) Representative: Marks & Clerk LLP

(57) **Abstract**

Provided is a display apparatus including a substrate, a first thin-film transistor, and a second thin-film transistor, wherein the first thin-film transistor includes a first active layer including an oxide and is disposed above the substrate, the second thin-film transistor includes a second active layer including an oxide and is disposed above the substrate, and the first thin-film transistor is disposed between the substrate and the second thin-film transistor in a thickness direction of the substrate such that a distance between the substrate and the first thin-film transistor has a smaller value than a distance between the substrate and the second thin-film transistor.

## Description

### BACKGROUND

### 1. Technical Field

Embodiments of the disclosure relate to a display apparatus.

### 2. Description of the Related Art

Recently, the uses of display apparatuses have become more diversified. As display apparatuses have become thinner and lighter, their range of uses has gradually expanded.

As the range of use of display apparatuses expands and technologies that utilize display apparatuses advance, the required image quality and high-resolution characteristics for display apparatuses are increasing.

Meanwhile, as display apparatuses are becoming thinner in a form similar to a flat panel, the number of steps in the manufacturing process increases and the complexity of the manufacturing process is also on the rise.

Thus, there are limitations in implementing high-resolution and high-quality display apparatuses through a stable manufacturing process.

### SUMMARY

Embodiments of the disclosure are directed to providing a display apparatus with high resolution and high image quality.

Additional aspects will be set forth in part in the description which follows and, in part, will be apparent from the description, or may be learned by practice of the presented embodiments of the disclosure.

According to an aspect of the disclosure, there is provided a display apparatus including a substrate, a first thin-film transistor, and a second thin-film transistor, wherein the first thin-film transistor includes a first active layer including an oxide and is disposed above the substrate, the second thin-film transistor includes a second active layer including an oxide and is disposed above the substrate, and the first thin-film transistor is disposed between the substrate and the second thin-film transistor in a thickness direction of the substrate such that a distance between the substrate and the first thin-film transistor has a smaller value than a distance between the substrate and the second thin-film transistor.

In an embodiment, the display apparatus may further include one or more interlayer insulating layers disposed between the first thin-film transistor and the second thin-film transistor.

In an embodiment, the first thin-film transistor and the second thin-film transistor may overlap in at least an area in the thickness direction of the substrate.

In an embodiment, the first active layer of the first thin-film transistor and the second active layer of the second thin-film transistor may overlap in at least an area in the thickness direction of the substrate.

In an embodiment, the first active layer of the first thin-film transistor and the second active layer of the second thin-film transistor may have different properties.

In an embodiment, the display apparatus may further include a conductive pattern portion overlapping the first active layer of the first thin-film transistor or the second active layer of the second thin-film transistor.

In an embodiment, the conductive pattern portion may be electrically connected to an area of the first thin-film transistor or an area of the second thin-film transistor through one or more contact holes.

In an embodiment, the first thin-film transistor may include one or more connection electrodes electrically connected to the first active layer, or the second thin-film transistor comprises one or more connection electrodes electrically connected to the second active layer, and the conductive pattern portion may be electrically connected to at least an area of the one or more connection electrodes.

In an embodiment, the display apparatus may further include an intermediate conductive layer disposed between the first thin-film transistor and the second thin-film transistor.

In an embodiment, the intermediate conductive layer may be formed to correspond to at least a width of the first active layer or the second active layer in one direction.

In an embodiments, through an area in which the intermediate conductive layer is not present, the first thin-film transistor or one or more conductive patterns disposed at a same layer as or a different layer from the first thin-film transistor may be electrically connected to the second thin-film transistor or one or more conductive patterns disposed at a same layer as or a different layer from the second thin-film transistor.

In an embodiment, the display apparatus may further include a display area and a peripheral area disposed on at least one side of the display area on the substrate, wherein one or more pixels may be disposed in the display area, and a driving circuit part area which generates or controls one or more signals for operations of the one or more pixels may be disposed in the peripheral area.

In an embodiment, the first thin-film transistor and the second thin-film transistor may be disposed to correspond to one pixel among the one or more pixels.

In an embodiment, in the one pixel, one or more thin-film transistors, each including an active layer including an oxide and configured for driving the one pixel, may be disposed adjacent to the first thin-film transistor, and one or more thin-film transistors, each including an active layer including an oxide and configured for driving the one pixel, may be disposed adjacent to the second thin-film transistor.

In an embodiment, the first thin-film transistor and the one or more thin-film transistors adjacent thereto may be disposed at a same layer, and the second thin-film transistor and the one or more thin-film transistors adjacent thereto may be disposed at a same layer.

In an embodiment, the first thin-film transistor and the second thin-film transistor may be disposed to correspond to the driving circuit part area.

In an embodiment, the first thin-film transistor and the second thin-film transistor may respectively correspond to two driving circuit parts of different types disposed in the driving circuit part area.

In an embodiment, in the driving circuit part area, a plurality of driving circuit parts may be disposed on each of an upper layer and a lower layer, with an interlayer insulating film in between, and a plurality of thin-film transistors each including an active layer including an oxide may be disposed at a same layer as the first thin-film transistor to be disposed adjacent to the first thin-film transistor, and a plurality of thin-film transistors each including an active layer including an oxide may be disposed at a same layer as the second thin-film transistor to be disposed adjacent to the second thin-film transistor, wherein the plurality of thin-film transistors may be disposed to correspond respectively to the plurality of driving circuit parts.

In an embodiment, driving circuits disposed in the upper and lower layers, with the interlayer insulating film in between, may be of different types.

According to another aspect of the disclosure, there is provided an electronic device including a display apparatus, and the display apparatus including a substrate, a first thin-film transistor and a second thin-film transistor, wherein the first thin-film transistor includes a first active layer including an oxide and is disposed above the substrate, the second thin-film transistor includes a second active layer including an oxide and is disposed above the substrate, and the first thin-film transistor is disposed between the substrate and the second thin-film transistor in a thickness direction of the substrate such that a distance between the substrate and the first thin-film transistor has a smaller value than a distance between the substrate and the second thin-film transistor.

In an embodiment, the display apparatus may further include one or more interlayer insulating layers disposed between the first thin-film transistor and the second thin-film transistor.

Other aspects, features, and advantages other than those described above will become apparent from the following drawings, claims, and detailed description of the disclosure.

At least some of the above and other features of the invention are set out in the claims.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic cross-sectional view illustrating a display apparatus according to an embodiment of the disclosure;
FIG. 2 is a schematic cross-sectional view illustrating a display apparatus according to another embodiment of the disclosure;
FIG. 3 is a schematic cross-sectional view illustrating a display apparatus according to another embodiment of the disclosure;
FIG. 4 is a schematic cross-sectional view illustrating a display apparatus according to another embodiment of the disclosure;
FIG. 5 is a schematic cross-sectional view illustrating a display apparatus according to another embodiment of the disclosure;
FIG. 6 is a schematic cross-sectional view illustrating a display apparatus according to another embodiment of the disclosure;
FIG. 7 is a schematic plan view illustrating a display apparatus according to another embodiment of the disclosure;
FIG. 8 is a cross-sectional view taken along line VIII-VIII' of FIG. 7;
FIG. 9 is a schematic cross-sectional view illustrating a display apparatus according to another embodiment of the disclosure;
FIG. 10 is a schematic plan view illustrating a display apparatus according to another embodiment of the disclosure;
FIG. 11 is a schematic cross-sectional view for describing area K of FIG. 10;
FIG. 12 is a schematic view illustrating an example of the structure of FIG. 11;
FIG. 13 is a schematic view illustrating one modified example of FIG. 11;
FIG. 14 is a schematic plan view illustrating a display apparatus according to another embodiment of the disclosure;
FIG. 15 is a schematic cross-sectional view for describing area K of FIG. 14;
FIG. 16 is a schematic view illustrating an example of the structure of FIG. 15;
FIG. 17 is a schematic diagram of an equivalent circuit of one pixel of the display apparatus according to an embodiment of the disclosure;
FIG. 18 is a schematic waveform diagram of driving signals for driving the pixel illustrated in FIG. 17; and
FIG. 19 is a schematic block diagram illustrating a display system according to an embodiment of the disclosure.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the disclosure. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the disclosure.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. The axis of the first direction DR1, the axis of the second direction DR2, and the axis of the third direction DR3 are not limited to three axes of a rectangular coordinate system, such as the X, Y, and Z-axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art. For example, "about" may mean within one or more standard deviations, or within ±20%, ±10%, or ±5% of the stated value.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the disclosure. The blocks, units, and/or modules of some embodiments may be physically combined into more complex blocks, units, and/or modules without departing from the scope of the disclosure.

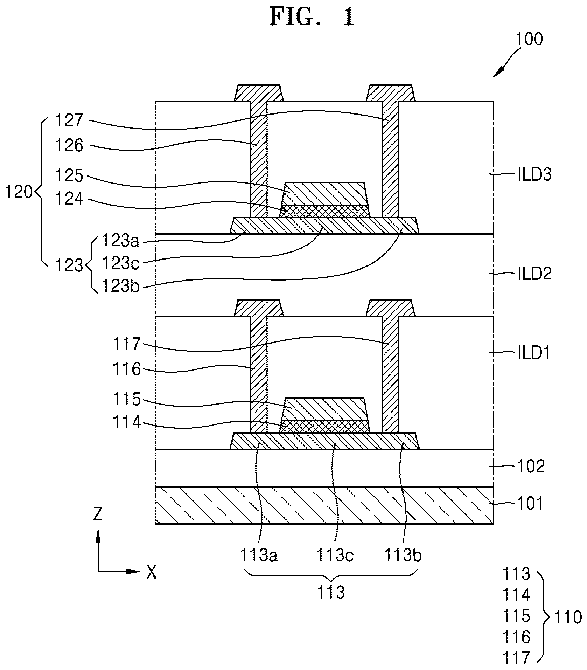

FIG. 1 is a schematic cross-sectional view illustrating a display apparatus according to an embodiment of the disclosure.

Referring to FIG. 1, a display apparatus 100 may include a substrate 101, a first thin-film transistor 110, and a second thin-film transistor 120.

Each of the first thin-film transistor 110 and the second thin-film transistor 120 may be disposed to generate one or more signals for the display apparatus 100. For example, the display apparatus 100 may include one or more pixels, and each of the first thin-film transistor 110 and the second thin-film transistor 120 may be disposed in the pixel, and may generate the same signal or different signals for the pixel to operate.

For example, the display apparatus 100 may include, for example, a non-display area around a display area including one or more pixels. The display apparatus 100 may include a driving circuit part area in the non-display area, and the driving circuit part area may include one or more driving circuit parts, which may generate one or more signals for the pixels to operate and transmit the signals to the pixels. Each of the first thin-film transistor 110 and the second thin-film transistor 120 may be disposed in the driving circuit part area of the non-display area, either in the same or in different driving circuit parts.

The first thin-film transistor 110 may include a first active layer 113 including at least an oxide, and the second thin-film transistor 120 may include a second active layer 123 including at least an oxide. A distance between the substrate 101 and the first thin-film transistor 110 may have a smaller value than that between the substrate 101 and the second thin-film transistor 120. Based on a thickness direction of the substrate 101 (e.g., a Z-axis direction in FIG. 1), the first thin-film transistor 110 may be disposed between the substrate 101 and the second thin-film transistor 120.

The display apparatus 100 will be described in more detail below.

The substrate 101 may include various materials. In detail, the substrate 101 may be formed of glass, metal, or other organic materials.

In another embodiment, the substrate 101 may be formed of a flexible material. For example, the substrate 101 may be formed so as to be readily flexed, bent, folded, or rolled.

The substrate 101 may be made of ultra-thin glass, metal, or plastic. For example, in case that using plastic, the substrate 101 may contain polyimide (PI), and for example, the substrate 101 may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polycarbonate, triacetate cellulose, and cellulose acetate propionate.

The substrate 101 may have a structure with one or more layers, such as a multi-layer structure. For example, the substrate 101 may include an organic layer (e.g., a resin-based material) and an inorganic layer, or, as a more specific example, may have a structure in which an inorganic layer is disposed between two organic layers.

In another embodiment, one or more buffer layers 102 may be disposed between the substrate 101 and the first thin-film transistor 110.

The buffer layers 102 may be disposed on the substrate 101. The buffer layers 102 may reduce or prevent the diffusion of impurities into the first thin-film transistor 110.

The buffer layer 102 may contain various materials, such as inorganic materials. For example, the buffer layer 102 may contain a silicon-based material. In another embodiment, the buffer layer 102 may include at least one of silicon nitride (SiNₓ), silicon oxide (SiOₓ), and silicon oxynitride (SiOₓN_{y}).

As another example, the buffer layer 102 may contain an oxide, and for example, may include at least one of metal oxides, such as aluminum oxide (AlOx).

In another embodiment, the buffer layer 102 may include a multi-layer of at least two layers or more.

The first thin-film transistor 110 may include the first active layer 113 and a first gate electrode 115.

The first thin-film transistor 110 may further include a first connection electrode 116 and a second connection electrode 117.

The first active layer 113 may be disposed on the buffer layer 102.

The first active layer 113 may include an oxide semiconductor. For example, the first active layer 113 may include zinc oxide (ZnOₓ), gallium oxide (GaOₓ), titanium oxide (TiOₓ), indium oxide (InOₓ), indium-gallium oxide (IGO), indium-zinc oxide (IZO), gallium-zinc oxide (GZO), zinc-magnesium oxide (ZMO), zinc-zirconium oxide (ZnZrₓO_{y}), indium-gallium-zinc oxide (IGZO), or indium-gallium-hafnium oxide (IGHO), and these oxides may be used alone or in combination with each other.

For example, the first active layer 113 may include indium-tin-gallium-zinc oxide (ITGZO).

The first active layer 113 may include a first connection area 113a, a second connection area 113b, and a first channel region 113c disposed therebetween.

Based on the thickness direction of the substrate 101, the first gate electrode 115 may overlap the first active layer 113, for example, on top of the first active layer 113.

The first gate insulating film 114 may be disposed to insulate (or to be disposed) between the first active layer 113 and the first gate electrode 115.

For example, the first gate insulating film 114 may be disposed on the first active layer 113. In another embodiment, the first gate insulating film 114 may overlap the first active layer 113. For example, the first gate insulating film 114 may be in contact with the first active layer 113.

In another embodiment, the first gate insulating film 114 may overlap the first channel region 113c of the first active layer 113 while being spaced apart from the first connection area 113a and the second connection area 113b of the first active layer 113. Accordingly, a first interlayer insulating layer ILD1 may be in direct contact with the first connection area 113a and the second connection area 113b. Through this structure, hydrogen may diffuse from the first interlayer insulating layer ILD1 disposed adjacent to the first connection area 113a and the second connection area 113b, thereby increasing the conductivity of the first connection area 113a and the second connection area 113b, which, for example, may become conductive.

The first gate insulating film 114 may include an insulating material. For example, the first gate insulating film 114 may include silicon oxide, silicon nitride, silicon oxynitride, and the like, and these may be used alone or in combination with each other.

The first gate electrode 115 may be disposed on the first gate insulating film 114. The first gate electrode 115 may overlap the first active layer 113, for example, to be in contact with the first gate insulating film 114.

The first gate electrode 115 may include a conductive material and may be formed of, for example, a metal, an alloy, a conductive metal oxide, a transparent conductive material, or the like.

For example, the first gate electrode 115 may include conductive materials such as molybdenum (Mo), aluminum (Al), copper (Cu), titanium (Ti), silver (Ag), tungsten (W), tungsten nitride (WN), nickel (Ni), chromium (Cr), chromium nitride (CrN), tantalum (Ta), platinum (Pt), scandium (Sc), indium-tin oxide (ITO), indium-zinc oxide (IZO), or the like, and may also include alloys of the conductive materials. The first gate electrode 115 may include a single layer or multilayer including the above-described materials.

The first interlayer insulating layer ILD1 may be disposed to insulate (or to be disposed) between the first gate electrode 115 and the first and second connection electrodes 116 and 117. For example, the first interlayer insulating layer ILD1 may be formed on top of the first gate electrode 115 and the first active layer 113 to cover the first gate electrode 115 and the first active layer 113.

The first interlayer insulating layer ILD1 may be disposed on the buffer layer 102. The first interlayer insulating layer ILD1 may include an insulating material.

For example, the first interlayer insulating layer ILD1 may include silicon oxide, silicon nitride, silicon oxynitride, or the like. Multiple contact holes may be defined in the first interlayer insulating layer ILD1.

The first connection electrode 116 and the second connection electrode 117 may be disposed on the first interlayer insulating layer ILD1. The first connection electrode 116 and the second connection electrode 117 may be in contact with the first active layer 113 through each of contact holes in the first interlayer insulating layer ILD1. For example, the first connection electrode 116 may be in contact with the first connection area 113a of the first active layer 113, and the second connection electrode 117 may be in contact with the second connection area 113b of the first active layer 113.

Based on a signal applied to the first gate electrode 115, the first connection electrode 116 and the second connection electrode 117 may be electrically connected to each other.

Each of the first connection electrode 116 and the second connection electrode 117 may include one or more of various conductive materials, such as metals, alloys, conductive metal oxides, or transparent conductive materials. For example, each of the first connection electrode 116 and the second connection electrode 117 may include materials such as silver (Ag), molybdenum (Mo), aluminum (Al), aluminum nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), indium-tin oxide (ITO), indium-zinc oxide (IZO), and the like.

The second thin-film transistor 120 may be disposed above the first thin-film transistor 110. For example, a second interlayer insulating layer ILD2 may be formed on the first interlayer insulating layer ILD1, and the second thin-film transistor 120 may be formed on the second interlayer insulating layer ILD2.

For example, the second interlayer insulating layer ILD2 may be formed to cover the first thin-film transistor 110.

The second interlayer insulating layer ILD2 may be formed of various insulating materials, and for example, the second interlayer insulating layer ILD2 may contain inorganic materials, for example, silicon oxide, silicon nitride, silicon oxynitride, and the like. The second interlayer insulating layer ILD2 may contain organic materials, polyacrylic resin, polyimide resin, acrylic resin, and the like.

In another embodiment, an intermediate insulating layer (not shown) may be further disposed between the first interlayer insulating layer ILD1 and the second interlayer insulating layer ILD2.

The second thin-film transistor 120 may include the second active layer 123 and a second gate electrode 125.

The second thin-film transistor 120 may further include a third connection electrode 126 and a fourth connection electrode 127.

The second active layer 123 may be disposed on the second interlayer insulating layer ILD2.

The second active layer 123 may include an oxide semiconductor. For example, the second active layer 123 may include zinc oxide (ZnOₓ), gallium oxide (GaOₓ), titanium oxide (TiOₓ), indium oxide (InOₓ), indium-gallium oxide (IGO), indium-zinc oxide (IZO), gallium-zinc oxide (GZO), zinc-magnesium oxide (ZMO), zinc-zirconium oxide (ZnZrₓO_{y}), indium-gallium-zinc oxide (IGZO), or indium-gallium-hafnium oxide (IGHO), and these oxides may be used alone or in combination with each other.

For example, the second active layer 123 may include indium-tin-gallium-zinc oxide (ITGZO).

The second active layer 123 may include a first connection area 123a, a second connection area 123b, and a second channel region 123c disposed therebetween.

The second active layer 123 may contain the same oxide-based material as the first active layer 113 and, for example, the second active layer 123 and the first active layer 113 may be formed of the same material.

The second active layer 123 may at least partially overlap the first active layer 113, and for example, the second active layer 123 may entirely overlap the first active layer 113.

By disposing the second active layer 123 to at least partially overlap the first active layer 113, an increased level of integration and a reduced non-display area of display apparatus 100 can be readily implemented.

The second gate electrode 125 may overlap the second active layer 123, and for example, may be disposed above the second active layer 123 in the thickness direction of the substrate 101.

A second gate insulating film 124 may be disposed to insulate (or to be disposed) between the second active layer 123 and the second gate electrode 125.

For example, the second gate insulating film 124 may be disposed on the second active layer 123. In another embodiment, the second gate insulating film 124 may overlap the second active layer 123. For example, the second gate insulating film 124 may be disposed to be in contact with the second active layer 123.

In another embodiment, the second gate insulating film 124 may overlap the second channel region 123c of the second active layer 123, and may be spaced apart from the first connection area 123a and the second connection area 123b of the second active layer 123. Accordingly, a third interlayer insulating layer ILD3 may be in direct contact with the first connection area 123a and the second connection area 123b. Through this structure, hydrogen may diffuse from the third interlayer insulating layer ILD3 disposed adjacent to the first connection area 123a and the second connection area 123b, thereby increasing the conductivity of the first connection area 123a and the second connection area 123b, which, for example, may become conductive.

The second gate insulating film 124 may include an insulating material. For example, the second gate insulating film 124 may include silicon oxide, silicon nitride, silicon oxynitride, and the like, and these may be used alone or in combination with each other.

The second gate electrode 125 may be disposed on the second gate insulating film 124. The second gate electrode 125 may overlap the second active layer 123, for example, to be in contact with the second gate insulating film 124.

The second gate electrode 125 may include a conductive material and may be formed of, for example, a metal, an alloy, a conductive metal oxide, a transparent conductive material, or the like.

For example, the second gate electrode 125 may include conductive materials such as molybdenum (Mo), aluminum (Al), copper (Cu), titanium (Ti), silver (Ag), tungsten (W), tungsten nitride (WN), nickel (Ni), chromium (Cr), chromium nitride (CrN), tantalum (Ta), platinum (Pt), scandium (Sc), indium-tin oxide (ITO), indium-zinc oxide (IZO), or the like, and may also include alloys of the conductive materials. The second gate electrode 125 may include a single layer or multilayer including the above-described materials.

The third interlayer insulating layer ILD3 may be disposed to insulate (or to be disposed) between the second gate electrode 125 and the third and fourth connection electrode 126 and 127. For example, the third interlayer insulating layer ILD3 may be formed on top of the second gate electrode 125 and the second active layer 123 to cover the second gate electrode 125 and the second active layer 123.

The third interlayer insulating layer ILD3 may be disposed on the second interlayer insulating layer ILD2.

The third interlayer insulating layer ILD3 may include an insulating material, such as silicon oxide, silicon nitride, silicon oxynitride, or the like. Multiple contact holes may be defined in the third interlayer insulating layer ILD3.

The third connection electrode 126 and the fourth connection electrode 127 may be disposed on the third interlayer insulating layer ILD3. The third connection electrode 126 and the fourth connection electrode 127 may be in contact with the second active layer 123 through each of contact holes in the third interlayer insulating layer ILD3. For example, the third connection electrode 126 may be in contact with the first connection area 123a of the second active layer 123, and the fourth connection electrode 127 may be in contact with the second connection area 123b of the second active layer 123.

Based on a signal applied to the second gate electrode 125, the third connection electrode 126 and the fourth connection electrode 127 may be electrically connected to each other.

Each of the third connection electrode 126 and the fourth connection electrode 127 may include one or more of various conductive materials, such as metals, alloys, conductive metal oxides, or transparent conductive materials. For example, each of the third connection electrode 126 and the fourth connection electrode 127 may include materials such as silver (Ag), molybdenum (Mo), aluminum (Al), aluminum nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), indium-tin oxide (ITO), indium-zinc oxide (IZO), and the like.

The first thin-film transistor 110 and the second thin-film transistor 120 may be disposed to have an overlapping area in the thickness direction of the substrate 101 (e.g., the Z-axis direction of FIG. 1). For example, at least the first active layer 113 of the first thin-film transistor 110 may overlap the second active layer 123 of the second thin-film transistor 120, and for example, the first gate electrode 115 may overlap the second gate electrode 125.

In the display apparatus 100 of the embodiment, the first thin-film transistor 110 may be disposed on the substrate 101, and the second thin-film transistor 120 may be disposed above the first thin-film transistor 110. The second active layer 123 including the oxide of the second thin-film transistor 120 may be disposed on the first active layer 113 including the oxide of the first thin-film transistor 110.

Through this structure, by forming the first active layer 113 without using high-energy processes (e.g., laser crystallization) in case that forming the first thin-film transistor 110 disposed at a lower position in the thickness direction of the substrate 101, and similarly forming the second active layer 123 without using high-energy processes (e.g., laser crystallization) in case that forming the second thin-film transistor 120 disposed at a higher position, thermal damage to the first thin-film transistor 110 located in the lower position can be reduced or prevented. It is possible to reduce or prevent the occurrence of stains on the first active layer 113 and the second active layer 123 during the high-energy processes (e.g., laser crystallization).

Through this process, it is possible to readily and safely form a structure in which the second thin-film transistor 120 is disposed above the first thin-film transistor 110, i.e., a structure in which multiple thin-film transistors are stacked. As a result, one or more circuits may be highly integrated and disposed, and a high resolution of the display apparatus 100 may be readily implemented.

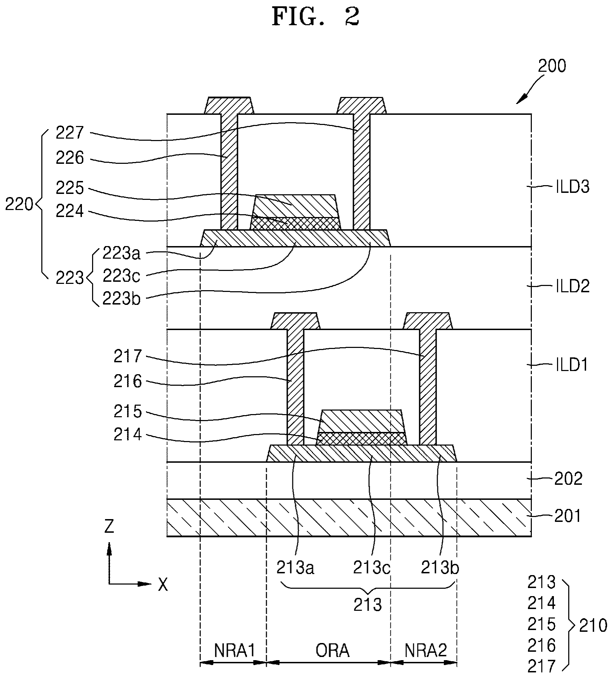

FIG. 2 is a schematic cross-sectional view illustrating a display apparatus according to another embodiment of the disclosure.

Referring to FIG. 2, a display apparatus 200 may include a substrate 201, a first thin-film transistor 210, and a second thin-film transistor 220.

For convenience of description, differences from the above-described embodiment will be mainly described.

The first thin-film transistor 210 may include a first active layer 213 including at least an oxide, and the second thin-film transistor 220 may include a second active layer 223 including at least an oxide. A distance between the substrate 201 and the first thin-film transistor 210 may have a smaller value than that between the substrate 201 and the second thin-film transistor 220. Based on a thickness direction of the substrate 201 (e.g., a Z-axis direction in FIG. 2), the first thin-film transistor 210 may be disposed between the substrate 201 and the second thin-film transistor 220. The first active layer 213 may include a first connection area 213a, a second connection area 213b, and a first channel region 213c disposed therebetween. The second active layer 223 may include a first connection area 223a, a second connection area 223b, and a second channel region 223c disposed therebetween.

The display apparatus 200 will be described in more detail below.

The substrate 201 may include various materials, and other details, including the material of the substrate 201, are substantially the same as those of the substrate 101 in the above-described embodiment, and thus detailed descriptions thereof will be omitted.

In another embodiment, one or more buffer layers 202 may be disposed between the substrate 201 and the first thin-film transistor 210, and since further details of the buffer layer 202 are substantially the same as those of the buffer layer 102 in the above-described embodiment, detailed descriptions thereof will be omitted.

The first thin-film transistor 210 may include the first active layer 213 and a first gate electrode 215.

The first thin-film transistor 210 may further include a first connection electrode 216 and a second connection electrode 217.

The first active layer 213 may be disposed on the buffer layer 202. The first active layer 213 may include an oxide semiconductor. Other further details, including the material of the first active layer 213, are substantially the same as those of the first active layer 113 in the above-described embodiment, and thus detailed descriptions thereof will be omitted.

Based on the thickness direction of the substrate 201, the first gate electrode 215 may overlap the first active layer 213, for example, on top of the first active layer 213.

The first gate insulating film 214 may be disposed to insulate (or to be disposed) between the first active layer 213 and the first gate electrode 215.

Since further details of the first gate insulating film 214 are substantially the same as those of the first gate insulating film 114 in the above-described embodiment, detailed descriptions thereof will be omitted.

The first gate electrode 215 may be disposed on the first gate insulating film 214. The first gate electrode 215 may overlap the first active layer 213, for example, to be in contact with the first gate insulating film 214.

Since further details of the first gate electrode 215 are substantially the same as those of the first gate electrode 115 in the above-described embodiment, detailed descriptions thereof will be omitted.

A first interlayer insulating layer ILD1 may be disposed to insulate (or to be disposed) between the first gate electrode 215 and the first and second connection electrodes 216 and 217. Further details of the first interlayer insulating layer ILD1 are substantially the same as those of the first interlayer insulating layer ILD1 in the above-described embodiment, and thus detailed descriptions thereof will be omitted.

The first connection electrode 216 and the second connection electrode 217 may be disposed on the first interlayer insulating layer ILD1. Further details of the first connection electrode 216 and the second connection electrode 217 are substantially the same as those of the first connection electrode 116 and the second connection electrode 117 in the above-described embodiment, and thus detailed descriptions thereof will be omitted.

The second thin-film transistor 220 may be disposed above the first thin-film transistor 210. For example, a second interlayer insulating layer ILD2 may be formed on the first interlayer insulating layer ILD1, and the second thin-film transistor 220 may be formed on the second interlayer insulating layer ILD2.

For example, the second interlayer insulating layer ILD2 may be formed to cover the first thin-film transistor 210. Further details of the second interlayer insulating layer ILD2 are substantially the same as those described in the above-described embodiment, and thus detailed descriptions thereof will be omitted.

The second thin-film transistor 220 may include the second active layer 223 and a second gate electrode 225.

The second thin-film transistor 220 may further include a third connection electrode 226 and a fourth connection electrode 227.

The second active layer 223 may be disposed on the second interlayer insulating layer ILD2.

The second active layer 223 may include an oxide semiconductor.

Further details, including the material of the second active layer 223, are substantially the same as those of the second active layer 123 in the above-described embodiment, and thus, detailed descriptions thereof will be omitted.

The second active layer 223 may contain the same oxide-based material as the first active layer 213 and, for example, the second active layer 223 and the first active layer 213 may be formed of the same material.

The second active layer 223 may at least partially overlap the first active layer 213, and for example, an overlapping area ORA, which is a partial area of the second active layer 223, may overlap the first active layer 213. A non-overlapping area NRA1, which is disposed adjacent to the overlapping area ORA that is a partial area of the second active layer 223, may not overlap the first active layer 213. A non-overlapping area NRA2, which is a partial area of the first active layer 213, may not overlap the second active layer 223.

By disposing the second active layer 223 to at least partially overlap the first active layer 213, an increased level of integration and a reduced non-display area of display apparatus 200 can be readily implemented.

By having the second active layer 223, which partially overlaps a part of the first active layer 213 and does not partially overlap another part of the first active layer 213, when designing circuit areas in an upper and lower stacked configuration in the thickness direction of the substrate 201, it is possible to precisely implement a design that reduces mutual signal interference by selectively controlling the areas where interference is reduced and the areas where interference is not reduced.

The second gate electrode 225 may overlap the second active layer 223, and for example, may be disposed above the second active layer 223 in the thickness direction of the substrate 201.

A second gate insulating film 224 may be disposed to insulate (or to be disposed) between the second active layer 223 and the second gate electrode 225.

Further details of the second gate insulating film 224 are substantially the same as those of the second gate insulating film 124 in the above-described embodiment, and thus detailed descriptions thereof will be omitted.

The second gate electrode 225 may be disposed on the second gate insulating film 224. The second gate electrode 225 may overlap the second active layer 223, for example, to be in contact with the second gate insulating film 224.

Further details of the second gate electrode 225 are substantially the same as those of the second gate electrode 125 in the above-described embodiment, and thus detailed descriptions thereof will be omitted.

A third interlayer insulating layer ILD3 may be disposed to insulate (or to be disposed) between the second gate electrode 225 and the third and fourth connection electrode 226 and 227. For example, the third interlayer insulating layer ILD3 may be formed on top of the second gate electrode 225 and the second active layer 223 to cover the second gate electrode 225 and the second active layer 223. Further details of the third interlayer insulating layer ILD3 are substantially the same as those of the third interlayer insulating layer ILD3 in the above-described embodiment, and thus detailed descriptions thereof will be omitted.

The third connection electrode 226 and the fourth connection electrode 227 may be disposed on the third interlayer insulating layer ILD3. Further details of the third connection electrode 226 and the fourth connection electrode 227 are substantially the same as those of the third connection electrode 126 and the fourth connection electrode 127 in the above-described embodiment, and thus detailed descriptions thereof will be omitted.

The first thin-film transistor 210 and the second thin-film transistor 220 may be disposed such that one area has an overlapping area in the thickness direction of the substrate 201 (e.g., the Z-axis direction in FIG. 2), and another area disposed adjacent to the overlapping area has a non-overlapping area. For example, at least the first active layer 213 of the first thin-film transistor 210 may overlap the second active layer 223 of the second thin-film transistor 220 in one area and may not overlap the second active layer 223 in another area.

In the display apparatus 200 of the embodiment, the first thin-film transistor 210 may be disposed on the substrate 201, and the second thin-film transistor 220 may be disposed above the first thin-film transistor 210. The second active layer 223 including the oxide of the second thin-film transistor 220 may be disposed above the first active layer 213 including the oxide of the first thin-film transistor 210.

Through this structure, by forming the first active layer 213 without using high-energy processes (e.g., laser crystallization) when forming the first thin-film transistor 210 disposed at a lower position in the thickness direction of the substrate 201, and similarly forming the second active layer 223 without using high-energy processes (e.g., laser crystallization) when forming the second thin-film transistor 220 disposed at a higher position, thermal damage to the first thin-film transistor 210 located in the lower position can be reduced or prevented. It is possible to reduce or prevent the occurrence of stains on the first active layer 213 and the second active layer 223 during the high-energy processes (e.g., laser crystallization).

Through this process, it is possible to readily and safely form a structure in which the second thin-film transistor 220 is disposed above the first thin-film transistor 210, i.e., a structure in which multiple thin-film transistors are stacked. As a result, one or more circuits may be highly integrated and disposed, and a high resolution of the display apparatus 200 may be readily implemented.

By having the second active layer 223 partially overlap and partially not overlap the first active layer 213, in case that designing circuit areas in an upper and lower stacked configuration in the thickness direction of the substrate 201, it is possible to precisely implement a design that reduces mutual signal interference by selectively controlling the areas where interference is reduced and the areas where interference is not reduced.

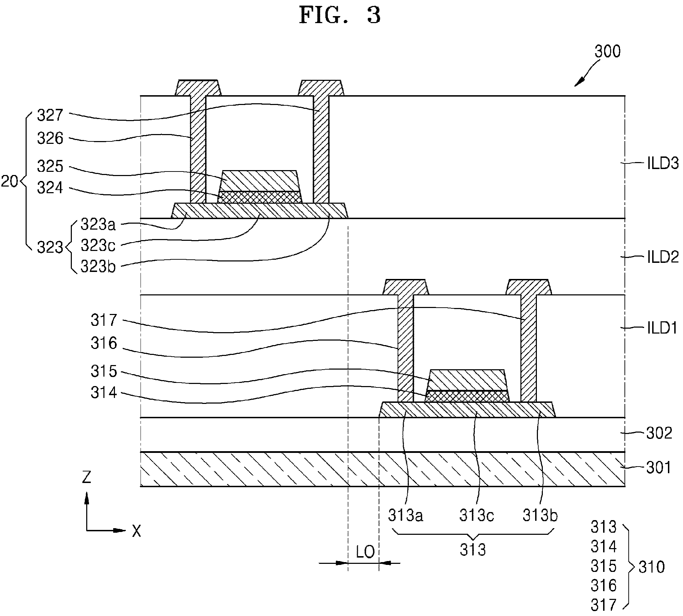

FIG. 3 is a schematic cross-sectional view illustrating a display apparatus according to another embodiment of the disclosure.

Referring to FIG. 3, a display apparatus 300 may include a substrate 301, a first thin-film transistor 310, and a second thin-film transistor 320.

For convenience of description, differences from the above-described embodiment will be mainly described.

The first thin-film transistor 310 may include a first active layer 313 including at least an oxide, and the second thin-film transistor 320 may include a second active layer 323 including at least an oxide. A distance between the substrate 301 and the first thin-film transistor 310 may have a smaller value than that between the substrate 301 and the second thin-film transistor 320. Based on a thickness direction of the substrate 301 (e.g., a Z-axis direction in FIG. 3), the first thin-film transistor 310 may be disposed between the substrate 301 and the second thin-film transistor 320. The first active layer 313 may include a first connection area 313a, a second connection area 313b, and a first channel region 313c disposed therebetween. The second active layer 323 may include a first connection area 323a, a second connection area 323b, and a second channel region 323c disposed therebetween.

The display apparatus 300 will be described in more detail below.

The substrate 301 may include various materials, and other details, including the material of the substrate 301, are substantially the same as those of the substrate 101 in the above-described embodiment, and thus detailed descriptions thereof will be omitted.

In another embodiment, one or more buffer layers 302 may be disposed between the substrate 301 and the first thin-film transistor 310, and since further details of the buffer layer 302 are substantially the same as those of the buffer layer 102 in the above-described embodiment, detailed descriptions thereof will be omitted.

The first thin-film transistor 310 may include the first active layer 313 and a first gate electrode 315.

The first thin-film transistor 310 may further include a first connection electrode 316 and a second connection electrode 317.

The first active layer 313 may be disposed on the buffer layer 302. The first active layer 313 may include an oxide semiconductor. Other further details, including the material of the first active layer 313, are substantially the same as those of the first active layer 113 in the above-described embodiment, and thus detailed descriptions thereof will be omitted.

Based on the thickness direction of the substrate 301, the first gate electrode 315 may overlap the first active layer 313, for example, on top of the first active layer 313.

The first gate insulating film 314 may be disposed to insulate (or to be disposed) between the first active layer 313 and the first gate electrode 315.

Since further details of the first gate insulating film 314 are substantially the same as those of the first gate insulating film 114 in the above-described embodiment, detailed descriptions thereof will be omitted.

The first gate electrode 315 may be disposed on the first gate insulating film 314. The first gate electrode 315 may overlap the first active layer 313, for example, to be in contact with the first gate insulating film 314.

Since further details of the first gate electrode 315 are substantially the same as those of the first gate electrode 115 in the above-described embodiment, detailed descriptions thereof will be omitted.

A first interlayer insulating layer ILD1 may be disposed to insulate (or to be disposed) between the first gate electrode 315 and the first and second connection electrodes 316 and 317. Further details of the first interlayer insulating layer ILD1 are substantially the same as those of the first interlayer insulating layer ILD1 in the above-described embodiment, and thus detailed descriptions thereof will be omitted.

The first connection electrode 316 and the second connection electrode 317 may be disposed on the first interlayer insulating layer ILD1. Further details of the first connection electrode 316 and the second connection electrode 317 are substantially the same as those of the first connection electrode 116 and the second connection electrode 117 in the above-described embodiment, and thus detailed descriptions thereof will be omitted.

The second thin-film transistor 320 may be disposed above the first thin-film transistor 310. For example, a second interlayer insulating layer ILD2 may be formed on the first interlayer insulating layer ILD1, and the second thin-film transistor 320 may be formed on the second interlayer insulating layer ILD2.

For example, the second interlayer insulating layer ILD2 may be formed to cover the first thin-film transistor 310. Further details of the second interlayer insulating layer ILD2 are substantially the same as those described in the above-described embodiment, and thus detailed descriptions thereof will be omitted.

The second thin-film transistor 320 may include the second active layer 323 and a second gate electrode 325.

The second thin-film transistor 320 may further include a third connection electrode 326 and a fourth connection electrode 327.

The second active layer 323 may be disposed on the second interlayer insulating layer ILD2.

The second active layer 323 may include an oxide semiconductor.

Further details, including the material of the second active layer 323, are substantially the same as those of the second active layer 123 in the above-described embodiment, and thus, detailed descriptions thereof will be omitted.

The second active layer 323 may contain the same oxide-based material as the first active layer 313 and, for example, the second active layer 323 and the first active layer 313 may be formed of the same material.

The second active layer 323 may be disposed so as not to overlap the first active layer 313. For example, the second active layer 323 may not overlap the first active layer 313 in the thickness direction of the substrate 301 (the Z-axis direction in FIG. 3).

For example, an extension line of a side surface of the first active layer 313 may be disposed to have a separation gap LO from an extension line of a side surface of the second active layer 323.

In another embodiment, when viewed in the thickness direction of the substrate 301 (or in a plan view), the first active layer 313 and the second active layer 323 may be disposed to be spaced apart from each other. Through this, it is possible to readily implement a vertically stacked structure of the first thin-film transistor 310 and the second thin-film transistor 320 in the thickness direction of the substrate 301, while reducing mutual signal interference between the first thin-film transistor 310 and the second thin-film transistor 320.

The second gate electrode 325 may overlap the second active layer 323, and for example, may be disposed above the second active layer 323 in the thickness direction of the substrate 301.

A second gate insulating film 324 may be disposed to insulate (or to be disposed) between the second active layer 323 and the second gate electrode 325.

Further details of the second gate insulating film 324 are substantially the same as those of the second gate insulating film 124 in the above-described embodiment, and thus detailed descriptions thereof will be omitted.

The second gate electrode 325 may be disposed on the second gate insulating film 324. The second gate electrode 325 may overlap the second active layer 323, for example, to be in contact with the second gate insulating film 324.

Further details of the second gate electrode 325 are substantially the same as those of the second gate electrode 125 in the above-described embodiment, and thus detailed descriptions thereof will be omitted.

A third interlayer insulating layer ILD3 may be disposed to insulate (or to be disposed) between the second gate electrode 325 and the third and fourth connection electrode 326 and 327. For example, the third interlayer insulating layer ILD3 may be formed on top of the second gate electrode 325 and the second active layer 323 to cover the second gate electrode 325 and the second active layer 323. Further details of the third interlayer insulating layer ILD3 are substantially the same as those of the third interlayer insulating layer ILD3 in the above-described embodiment, and thus detailed descriptions thereof will be omitted.

The third connection electrode 326 and the fourth connection electrode 327 may be disposed on the third interlayer insulating layer ILD3. Further details of the third connection electrode 326 and the fourth connection electrode 327 are substantially the same as those of the third connection electrode 126 and the fourth connection electrode 127 in the above-described embodiment, and thus detailed descriptions thereof will be omitted.

The first thin-film transistor 310 and the second thin-film transistor 320 may be vertically stacked in the thickness direction of the substrate 301 (e.g., the Z-axis direction in FIG. 3). The second active layer 323 may be disposed so as not to overlap the first active layer 313. For example, the second active layer 323 may not overlap the first active layer 313 in the thickness direction of the substrate 301 (the Z-axis direction in FIG. 3).

In the display apparatus 300 of the embodiment, the first thin-film transistor 310 may be disposed on the substrate 301, and the second thin-film transistor 320 may be disposed above the first thin-film transistor 310. The second active layer 323 including the oxide of the second thin-film transistor 320 may be disposed above the first active layer 313 including the oxide of the first thin-film transistor 310.

Through this structure, by forming the first active layer 313 without using high-energy processes (e.g., laser crystallization) in case that forming the first thin-film transistor 310 disposed at a lower position in the thickness direction of the substrate 301, and similarly forming the second active layer 323 without using high-energy processes (e.g., laser crystallization) in case that forming the second thin-film transistor 320 disposed at a higher position, thermal damage to the first thin-film transistor 310 located in the lower position can be reduced or prevented. It is possible to reduce or prevent the occurrence of stains on the first active layer 313 and the second active layer 323 during the high-energy processes (e.g., laser crystallization).

Through this process, it is possible to readily and safely form a structure in which the second thin-film transistor 320 is disposed above the first thin-film transistor 310, i.e., a structure in which multiple thin-film transistors are stacked. As a result, one or more circuits may be highly integrated and disposed, and a high resolution of the display apparatus 300 may be readily implemented.

By arranging the first active layer 313 and the second active layer 323 to be spaced apart from each other in the thickness direction of the substrate 301, it is possible to readily implement a vertically stacked structure of the first thin-film transistor 310 and the second thin-film transistor 320 in the thickness direction of the substrate 301, while reducing mutual signal interference between the first thin-film transistor 310 and the second thin-film transistor 320.

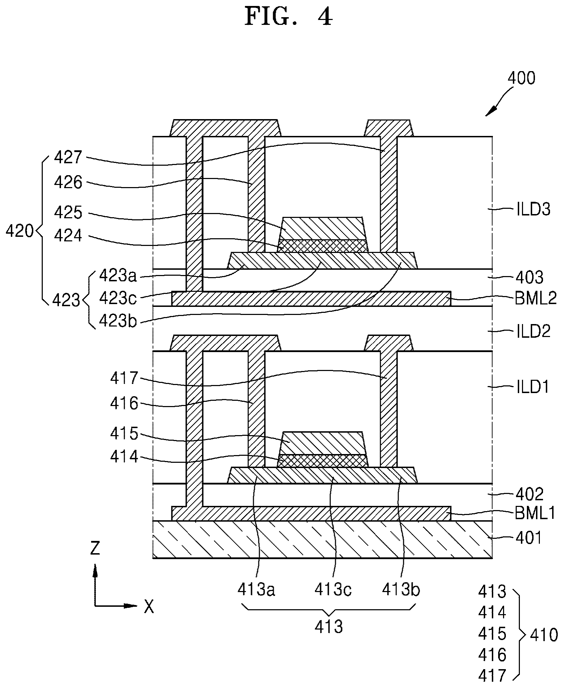

FIG. 4 is a schematic cross-sectional view illustrating a display apparatus according to another embodiment of the disclosure.

Referring to FIG. 4, a display apparatus 400 may include a substrate 401, a first thin-film transistor 410, and a second thin-film transistor 420.

A first conductive pattern portion BML1 or a second conductive pattern portion BML2 may be further included. In FIG. 4, both the first conductive pattern portion BML1 and the second conductive pattern portion BML2 are illustrated, but this is another embodiment, and the display apparatus 400 may include only one of the first conductive pattern portion BML1 and the second conductive pattern portion BML2.

For convenience of description, differences from the above-described embodiment will be mainly described.

The first thin-film transistor 410 may include a first active layer 413 including at least an oxide, and the second thin-film transistor 420 may include a second active layer 423 including at least an oxide. A distance between the substrate 401 and the first thin-film transistor 410 may have a smaller value than that between the substrate 401 and the second thin-film transistor 420. Based on a thickness direction of the substrate 401 (e.g., a Z-axis direction in FIG. 4), the first thin-film transistor 410 may be disposed between the substrate 401 and the second thin-film transistor 420. The first active layer 413 may include a first connection area 413a, a second connection area 413b, and a first channel region 413c disposed therebetween. The second active layer 423 may include a first connection area 423a, a second connection area 423b, and a second channel region 423c disposed therebetween.

The display apparatus 400 will be described in more detail below.

The substrate 401 may include various materials, and other details, including the material of the substrate 401, are substantially the same as those of the substrate 101 in the above-described embodiment, and thus detailed descriptions thereof will be omitted.

In another embodiment, one or more buffer layers 402 may be disposed between the substrate 401 and the first thin-film transistor 410, and since further details of the buffer layer 402 are substantially the same as those of the buffer layer 102 in the above-described embodiment, detailed descriptions thereof will be omitted.

The first thin-film transistor 410 may include the first active layer 413 and a first gate electrode 415.

The first thin-film transistor 410 may further include a first connection electrode 416 and a second connection electrode 417.

The first conductive pattern portion BML1 may be disposed between the first active layer 413 and the substrate 401.

For example, the first conductive pattern portion BML1 may have an area overlapping the first active layer 413 and may be disposed between the substrate 401 and the buffer layer 402.

The first conductive pattern portion BML1 may be utilized as a light-blocking member that protects the first active layer 413 or the first thin-film transistor 410 by reducing or blocking light that may enter the substrate 401. To this end, the first conductive pattern portion BML1 may contain light-blocking and/or light-absorbing materials. For example, the first conductive pattern portion BML1 may include an opaque metal layer.

In another embodiment, the first conductive pattern portion BML1 may be electrically connected to the first connection electrode 416 or the second connection electrode 417 through a contact hole that sequentially passes through a first interlayer insulating layer ILD1 and the buffer layer 402. Through this, a driving range of a predetermined voltage supplied to the first gate electrode 415 of the first thin-film transistor 410 may be expanded, and as another example, a channel area of the first active layer 413 may be stabilized.

In another embodiment, the first conductive pattern portion BML1 may include various metals and may be formed as a single layer made of a suitable (or selected) material from the group consisting of copper (Cu), molybdenum (Mo), tungsten (W), neodymium (Nd), titanium (Ti), aluminum (Al), silver (Ag), and alloys thereof, either individually or as a mixture. In another embodiment, to reduce wiring resistance, the first conductive pattern portion BML1 may be formed as a double-layer or multi-layer structure using low-resistance materials such as molybdenum (Mo), titanium (Ti), copper (Cu), aluminum (Al), or silver (Ag).

The first active layer 413 may be disposed on the buffer layer 402. The first active layer 413 may include an oxide semiconductor. Other further details, including the material of the first active layer 413, are substantially the same as those of the first active layer 113 in the above-described embodiment, and thus detailed descriptions thereof will be omitted.

Based on the thickness direction of the substrate 401, the first gate electrode 415 may overlap the first active layer 413, for example, on top of the first active layer 413.

The first gate insulating film 414 may be disposed to insulate (or to be disposed) between the first active layer 413 and the first gate electrode 415.

Since further details of the first gate insulating film 414 are substantially the same as those of the first gate insulating film 114 in the above-described embodiment, detailed descriptions thereof will be omitted.

The first gate electrode 415 may be disposed on the first gate insulating film 414. The first gate electrode 415 may overlap the first active layer 413, for example, to be in contact with the first gate insulating film 414.

Since further details of the first gate electrode 415 are substantially the same as those of the first gate electrode 115 in the above-described embodiment, detailed descriptions thereof will be omitted.

The first interlayer insulating layer ILD1 may be disposed to insulate (or to be disposed) between the first gate electrode 415 and the first and second connection electrodes 416 and 417. Further details of the first interlayer insulating layer ILD1 are substantially the same as those of the first interlayer insulating layer ILD1 in the above-described embodiment, and thus detailed descriptions thereof will be omitted.

The first connection electrode 416 and the second connection electrode 417 may be disposed on the first interlayer insulating layer ILD1. Further details of the first connection electrode 416 and the second connection electrode 417 are substantially the same as those of the first connection electrode 116 and the second connection electrode 117 in the above-described embodiment, and thus detailed descriptions thereof will be omitted.

The second thin-film transistor 420 may be disposed above the first thin-film transistor 410. For example, a second interlayer insulating layer ILD2 may be formed on the first interlayer insulating layer ILD1, and the second thin-film transistor 420 may be formed on the second interlayer insulating layer ILD2.

For example, the second interlayer insulating layer ILD2 may be formed to cover the first thin-film transistor 410. Further details of the second interlayer insulating layer ILD2 are substantially the same as those described in the above-described embodiment, and thus detailed descriptions thereof will be omitted.

The second thin-film transistor 420 may include the second active layer 423 and a second gate electrode 425.

The second thin-film transistor 420 may further include a third connection electrode 426 and a fourth connection electrode 427.

The second conductive pattern portion BML2 may be disposed between the second active layer 423 and the second interlayer insulating layer ILD2.

For example, the second conductive pattern portion BML2 may have an area overlapping the second active layer 423 and may be disposed between the second active layer 423 and the second interlayer insulating layer ILD2.

The second conductive pattern portion BML2 may be utilized as a light-blocking member that protects the second active layer 423 or the second thin-film transistor 420 by reducing or blocking light that may enter the substrate 401. To this end, the second conductive pattern portion BML2 may contain light-blocking and/or light-absorbing materials. For example, the second conductive pattern portion BML2 may include an opaque metal layer.

In another embodiment, the second conductive pattern portion BML2 may be electrically connected to the third connection electrode 426 or the fourth connection electrode 427 through a contact hole that sequentially passes through a third interlayer insulating layer ILD3 and an upper buffer layer 403. Through this, a driving range of a predetermined voltage supplied to the second gate electrode 425 of the second thin-film transistor 420 may be expanded, and as another example, a channel area of the second active layer 423 may be stabilized.

In another embodiment, the second conductive pattern portion BML2 may include various metals and may be formed as a single layer made of a suitable (or selected) material from the group consisting of copper (Cu), molybdenum (Mo), tungsten (W), neodymium (Nd), titanium (Ti), aluminum (Al), silver (Ag), and alloys thereof, either individually or as a mixture. In another embodiment, to reduce wiring resistance, the second conductive pattern portion BML2 may be formed as a double-layer or multi-layer structure using low-resistance materials such as molybdenum (Mo), titanium (Ti), copper (Cu), aluminum (Al), or silver (Ag).

One or more upper buffer layers 403 may be disposed between the second conductive pattern portion BML2 and the second active layer 423, and the upper buffer layer 403 may include one or more of the materials included in the buffer layer 402 and, for example, may be formed of the same material as the buffer layer 402.

The second active layer 423 may be disposed on the second interlayer insulating layer ILD2.

The second active layer 423 may include an oxide semiconductor.

Further details, including the material of the second active layer 423, are substantially the same as those of the second active layer 123 in the above-described embodiment, and thus, detailed descriptions thereof will be omitted.

The second active layer 423 may contain the same oxide-based material as the first active layer 413 and, for example, the second active layer 423 and the first active layer 413 may be formed of the same material.

The second active layer 423 may at least partially overlap the first active layer 413, or, in another embodiment, may not overlap the first active layer 413, as illustrated in FIG. 3.

The second gate electrode 425 may overlap the second active layer 423, and for example, may be disposed above the second active layer 423 in the thickness direction of the substrate 401.

A second gate insulating film 424 may be disposed to insulate (or to be disposed) between the second active layer 423 and the second gate electrode 425.

Further details of the second gate insulating film 424 are substantially the same as those of the second gate insulating film 124 in the above-described embodiment, and thus detailed descriptions thereof will be omitted.

The second gate electrode 425 may be disposed on the second gate insulating film 424. The second gate electrode 425 may overlap the second active layer 423, for example, to be in contact with the second gate insulating film 424.

Further details of the second gate electrode 425 are substantially the same as those of the second gate electrode 125 in the above-described embodiment, and thus detailed descriptions thereof will be omitted.

The third interlayer insulating layer ILD3 may be disposed to insulate (or to be disposed) between the second gate electrode 425 and the third and fourth connection electrode 426 and 427. For example, the third interlayer insulating layer ILD3 may be formed on top of the second gate electrode 425 and the second active layer 423 to cover the second gate electrode 425 and the second active layer 423. Further details of the third interlayer insulating layer ILD3 are substantially the same as those of the third interlayer insulating layer ILD3 in the above-described embodiment, and thus detailed descriptions thereof will be omitted.

The third connection electrode 426 and the fourth connection electrode 427 may be disposed on the third interlayer insulating layer ILD3. Further details of the third connection electrode 426 and the fourth connection electrode 427 are substantially the same as those of the third connection electrode 126 and the fourth connection electrode 127 in the above-described embodiment, and thus detailed descriptions thereof will be omitted.

In the display apparatus 400 of the embodiment, the first thin-film transistor 410 may be disposed on the substrate 401, and the second thin-film transistor 420 may be disposed above the first thin-film transistor 410. The second active layer 423 including the oxide of the second thin-film transistor 420 may be disposed above the first active layer 413 including the oxide of the first thin-film transistor 410.

Through this structure, by forming the first active layer 413 without using high-energy processes (e.g., laser crystallization) in case that forming the first thin-film transistor 410 disposed at a lower position in the thickness direction of the substrate 401, and similarly forming the second active layer 423 without using high-energy processes (e.g., laser crystallization) in case that forming the second thin-film transistor 420 disposed at a higher position, thermal damage to the first thin-film transistor 410 located in the lower position can be reduced or prevented. It is possible to reduce or prevent the occurrence of stains on the first active layer 413 and the second active layer 423 during the high-energy processes (e.g., laser crystallization).

Through this process, it is possible to readily and safely form a structure in which the second thin-film transistor 420 is disposed above the first thin-film transistor 410, i.e., a structure in which multiple thin-film transistors are stacked. As a result, one or more circuits may be highly integrated and disposed, and a high resolution of the display apparatus 400 may be readily implemented.

The display apparatus 400 may reduce or prevent changes in the physical or electrical properties of the first active layer 413 or the second active layer 423, which contain oxides, due to light, by including the first conductive pattern portion BML1 or the second conductive pattern portion BML2. By arranging the first conductive pattern portion BML1 or the second conductive pattern portion BML2 to be electrically connected to the conductive layer (e.g., one of the connection electrodes) of the first thin-film transistor 410 or the second thin-film transistor 420, the first thin-film transistor 410 or the second thin-film transistor 420 may have improved electrical properties, and precise control properties thereof may also be enhanced. Through this, the precise driving characteristics of the display apparatus 400 may be improved, thereby facilitating an easier implementation of high resolution.

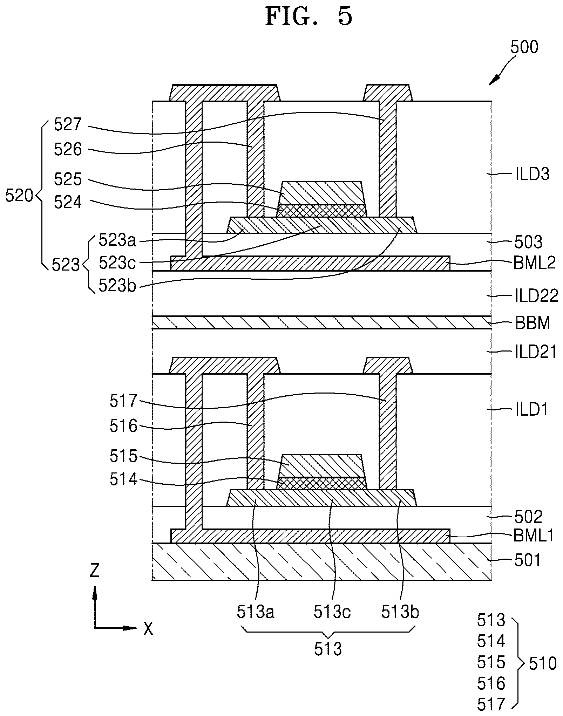

FIG. 5 is a schematic cross-sectional view illustrating a display apparatus according to another embodiment of the disclosure;

Referring to FIG. 5, a display apparatus 500 may include a substrate 501, a first thin-film transistor 510, and a second thin-film transistor 520.

The display apparatus 500 may further include an intermediate conductive layer BBM between the first thin-film transistor 510 and the second thin-film transistor 520.

For convenience of description, differences from the above-described embodiment will be mainly described.

The first thin-film transistor 510 may include a first active layer 513 including at least an oxide, and the second thin-film transistor 520 may include a second active layer 523 including at least an oxide. A distance between the substrate 501 and the first thin-film transistor 510 may have a smaller value than that between the substrate 501 and the second thin-film transistor 520. Based on a thickness direction of the substrate 501 (e.g., a Z-axis direction in FIG. 5), the first thin-film transistor 510 may be disposed between the substrate 501 and the second thin-film transistor 520. The first active layer 513 may include a first connection area 513a, a second connection area 513b, and a first channel region 513c disposed therebetween. The second active layer 523 may include a first connection area 523a, a second connection area 523b, and a second channel region 523c disposed therebetween.

The display apparatus 500 will be described in more detail below.

The substrate 501 may include various materials, and other details, including the material of the substrate 501, are substantially the same as those of the substrate 101 in the above-described embodiment, and thus detailed descriptions thereof will be omitted.

In another embodiment, one or more buffer layers 502 may be disposed between the substrate 501 and the first thin-film transistor 510, and since further details of the buffer layer 502 are substantially the same as those of the buffer layer 102 in the above-described embodiment, detailed descriptions thereof will be omitted.

The first thin-film transistor 510 may include the first active layer 513 and a first gate electrode 515.

The first thin-film transistor 510 may further include a first connection electrode 516 and a second connection electrode 517.

In another embodiment, a first conductive pattern portion BML1 may be disposed between the first active layer 513 and the substrate 501. Since further details of the first conductive pattern portion BML1 are substantially the same as those of the first conductive pattern portion BML1 in the above-described embodiment, detailed descriptions thereof will be omitted.

The first active layer 513 may be disposed on the buffer layer 502. The first active layer 513 may include an oxide semiconductor. Other further details, including the material of the first active layer 513, are substantially the same as those of the first active layer 113 in the above-described embodiment, and thus detailed descriptions thereof will be omitted.

Based on the thickness direction of the substrate 501, the first gate electrode 515 may overlap the first active layer 513, for example, on top of the first active layer 513.

The first gate insulating film 514 may be disposed to insulate (or to be disposed) between the first active layer 513 and the first gate electrode 515.

Since further details of the first gate insulating film 514 are substantially the same as those of the first gate insulating film 114 in the above-described embodiment, detailed descriptions thereof will be omitted.

The first gate electrode 515 may be disposed on the first gate insulating film 514. The first gate electrode 515 may overlap the first active layer 513, for example, to be in contact with the first gate insulating film 514.

Since further details of the first gate electrode 515 are substantially the same as those of the first gate electrode 115 in the above-described embodiment, detailed descriptions thereof will be omitted.

A first interlayer insulating layer ILD1 may be disposed to insulate (or to be disposed) between the first gate electrode 515 and the first and second connection electrodes 516 and 517. Further details of the first interlayer insulating layer ILD1 are substantially the same as those of the first interlayer insulating layer ILD1 in the above-described embodiment, and thus detailed descriptions thereof will be omitted.

The first connection electrode 516 and the second connection electrode 517 may be disposed on the first interlayer insulating layer ILD1. Further details of the first connection electrode 516 and the second connection electrode 517 are substantially the same as those of the first connection electrode 116 and the second connection electrode 117 in the above-described embodiment, and thus detailed descriptions thereof will be omitted.

The second thin-film transistor 520 may be disposed above the first thin-film transistor 510.

For example, the intermediate conductive layer BBM may be disposed between the first thin-film transistor 510 and the second thin-film transistor 520.

The intermediate conductive layer BBM may include a conductive material, and may include one of various metals.

The intermediate conductive layer BBM may be disposed between the first thin-film transistor 510 and the second thin-film transistor 520 to reduce electrical signal interference that may occur between the first thin-film transistor 510 and the second thin-film transistor 520.

The intermediate conductive layer BBM may be formed to overlap at least one area of each of the first thin-film transistor 510 and the second thin-film transistor 520.

In another embodiment, the intermediate conductive layer BBM may be electrically connected to a conductive layer in the same layer as or above the intermediate conductive layer BBM, for example, may be electrically connected to a conductive layer in the same layer as or above one of the components of the second thin-film transistor 520, through a contact hole.

In another embodiment, the intermediate conductive layer BBM may be electrically connected to a conductive layer in the same layer as or below the intermediate conductive layer BBM, for example, may be electrically connected to a conductive layer in the same layer as or above one of the components of the first thin-film transistor 510, through a contact hole.

In order to smoothly implement the above structure, the intermediate conductive layer BBM may have a width corresponding to or greater than a width of each of the first thin-film transistor 510 and the second thin-film transistor 520 in one direction. In another embodiment, the intermediate conductive layer BBM may be formed to overlap while corresponding to at least a width of each of the first active layer 513 and the second active layer 523 in one direction, and may be formed with a width extending beyond the above width.

The intermediate conductive layer BBM may be disposed between insulating layers, such as a lower layer ILD21 and an upper layer ILD22 of a second interlayer insulating layer.

The second thin-film transistor 520 may include the second active layer 523 and a second gate electrode 525.

The second thin-film transistor 520 may further include a third connection electrode 526 and a fourth connection electrode 527.

In another embodiment, the second conductive pattern portion BML2 may be disposed between the second active layer 523 and the second interlayer insulating layer ILD2. Further details of the second conductive pattern portion BML2 are substantially the same as those of the second conductive pattern portion BML2 in the above-described embodiment, and thus detailed descriptions thereof will be omitted.

In another embodiment, one or more upper buffer layers 503 may be disposed between the second conductive pattern portion BML2 and the second active layer 523.

The second active layer 523 may be disposed on the second interlayer insulating layer ILD2.

The second active layer 523 may include an oxide semiconductor.

Further details, including the material of the second active layer 523, are substantially the same as those of the second active layer 123 in the above-described embodiment, and thus, detailed descriptions thereof will be omitted.

The second active layer 523 may contain the same oxide-based material as the first active layer 513 and, for example, the second active layer 523 and the first active layer 513 may be formed of the same material.

The second active layer 523 may at least partially overlap the first active layer 513, or in another embodiment, may not overlap the first active layer 513 as illustrated in FIG. 3.

The second gate electrode 525 may overlap the second active layer 523, and for example, may be disposed above the second active layer 523 in the thickness direction of the substrate 501.

A second gate insulating film 524 may be disposed to insulate (or to be disposed) between the second active layer 523 and the second gate electrode 525.

Further details of the second gate insulating film 524 are substantially the same as those of the second gate insulating film 124 in the above-described embodiment, and thus detailed descriptions thereof will be omitted.

The second gate electrode 525 may be disposed on the second gate insulating film 524. The second gate electrode 525 may overlap the second active layer 523, for example, to be in contact with the second gate insulating film 524.

Further details of the second gate electrode 525 are substantially the same as those of the second gate electrode 125 in the above-described embodiment, and thus detailed descriptions thereof will be omitted.

A third interlayer insulating layer ILD3 may be disposed to insulate (or to be disposed) between the second gate electrode 525 and the third and fourth connection electrode 526 and 527. For example, the third interlayer insulating layer ILD3 may be formed on top of the second gate electrode 525 and the second active layer 523 to cover the second gate electrode 525 and the second active layer 523. Further details of the third interlayer insulating layer ILD3 are substantially the same as those of the third interlayer insulating layer ILD3 in the above-described embodiment, and thus detailed descriptions thereof will be omitted.

The third connection electrode 526 and the fourth connection electrode 527 may be disposed on the third interlayer insulating layer ILD3. Further details of the third connection electrode 526 and the fourth connection electrode 527 are substantially the same as those of the third connection electrode 126 and the fourth connection electrode 127 in the above-described embodiment, and thus detailed descriptions thereof will be omitted.

In the display apparatus 500 of the embodiment, the first thin-film transistor 510 may be disposed on the substrate 501, and the second thin-film transistor 520 may be disposed above the first thin-film transistor 510. The second active layer 523 including the oxide of the second thin-film transistor 520 may be disposed above the first active layer 513 including the oxide of the first thin-film transistor 510.

Through this structure, by forming the first active layer 513 without using high-energy processes (e.g., laser crystallization) in case that forming the first thin-film transistor 510 disposed at a lower position in the thickness direction of the substrate 501, and similarly forming the second active layer 523 without using high-energy processes (e.g., laser crystallization) in case that forming the second thin-film transistor 520 disposed at a higher position, thermal damage to the first thin-film transistor 510 located in the lower position can be reduced or prevented. It is possible to reduce or prevent the occurrence of stains on the first active layer 513 and the second active layer 523 during the high-energy processes (e.g., laser crystallization).

Through this process, it is possible to readily and safely form a structure in which the second thin-film transistor 520 is disposed above the first thin-film transistor 510, i.e., a structure in which multiple thin-film transistors are stacked. As a result, one or more circuits may be highly integrated and disposed, and a high resolution of the display apparatus 500 may be readily implemented.

In the display apparatus 500, the intermediate conductive layer BBM may be disposed between the first thin-film transistor 510 and the second thin-film transistor 520. Through this structure, it is possible to reduce or prevent electrical signal interference between the first thin-film transistor 510 and the second thin-film transistor 520.

By electrically connecting the intermediate conductive layer BBM to the conductive layers in different areas located on the upper and lower sides in the thickness direction of the substrate 501 (e.g., through one or more contact holes), the implementation of various electrical signal may be achieved.

By electrically connecting the conductive layers in different areas on the upper and lower sides in the thickness direction of the substrate 501, through the intermediate conductive layer BBM, the parts of the conductive layers that require electrical connections on the upper and lower sides can be connected.

Through this, the implementation of various electrical circuit configurations of the display apparatus 500 may be readily achieved.

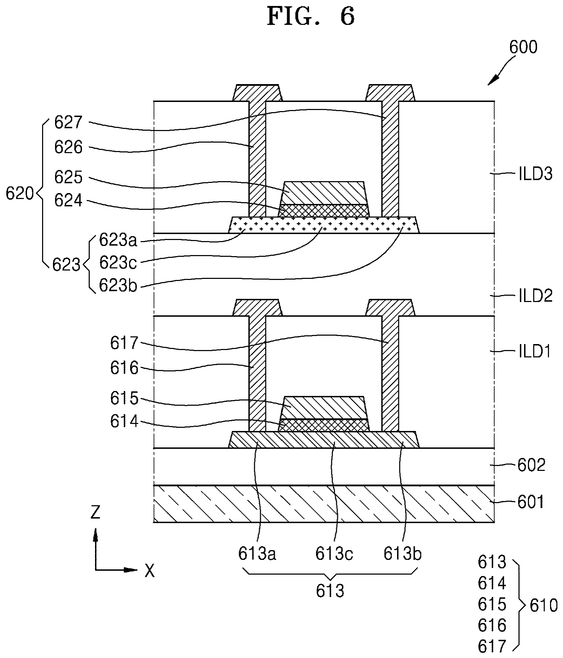

FIG. 6 is a schematic cross-sectional view illustrating a display apparatus according to another embodiment of the disclosure;

Referring to FIG. 6, a display apparatus 600 may include a substrate 601, a first thin-film transistor 610, and a second thin-film transistor 620.

For convenience of description, differences from the above-described embodiment will be mainly described.

A first active layer 613 of the first thin-film transistor 610 and a second active layer 623 of the second thin-film transistor 620 of the embodiment may be formed with at least one differing characteristic.

This will be described in detail below.

The first thin-film transistor 610 may include the first active layer 613 including at least an oxide, and the second thin-film transistor 620 may include the second active layer 623 including at least an oxide. A distance between the substrate 601 and the first thin-film transistor 610 may have a smaller value than that between the substrate 601 and the second thin-film transistor 620. Based on a thickness direction of the substrate 601 (e.g., a Z-axis direction in FIG. 6), the first thin-film transistor 610 may be disposed between the substrate 601 and the second thin-film transistor 620. The first active layer 613 may include a first connection area 613a, a second connection area 613b, and a first channel region 613c disposed therebetween. The second active layer 623 may include a first connection area 623a, a second connection area 623b, and a second channel region 623c disposed therebetween.

The display apparatus 600 will be described in more detail below.

The substrate 601 may include various materials, and other details, including the material of the substrate 601, are substantially the same as those of the substrate 101 in the above-described embodiment, and thus detailed descriptions thereof will be omitted.

In another embodiment, one or more buffer layers 602 may be disposed between the substrate 601 and the first thin-film transistor 610, and since further details of the buffer layer 602 are substantially the same as those of the buffer layer 102 in the above-described embodiment, detailed descriptions thereof will be omitted.

The first thin-film transistor 610 may include the first active layer 613 and a first gate electrode 615.

The first thin-film transistor 610 may further include a first connection electrode 616 and a second connection electrode 617.

The first active layer 613 may be disposed on the buffer layer 602.

The first active layer 613 may include an oxide semiconductor. For example, the first active layer 613 may include zinc oxide (ZnOₓ), gallium oxide (GaOₓ), titanium oxide (TiOx), indium oxide (InOₓ), indium-gallium oxide (IGO), indium-zinc oxide (IZO), gallium-zinc oxide (GZO), zinc-magnesium oxide (ZMO), zinc-zirconium oxide (ZnZrₓO_{y}), indium-gallium-zinc oxide (IGZO), or indium-gallium-hafnium oxide (IGHO), and these oxides may be used alone or in combination with each other.

For example, the first active layer 613 may include indium-tin-gallium-zinc oxide (ITGZO).

Based on the thickness direction of the substrate 601, the first gate electrode 615 may overlap the first active layer 613, for example, on top of the first active layer 613.

The first gate insulating film 614 may be disposed to insulate (or to be disposed) between the first active layer 613 and the first gate electrode 615.

Since further details of the first gate insulating film 614 are substantially the same as those of the first gate insulating film 114 in the above-described embodiment, detailed descriptions thereof will be omitted.

The first gate electrode 615 may be disposed on the first gate insulating film 614. The first gate electrode 615 may overlap the first active layer 613, for example, to be in contact with the first gate insulating film 614.

Since further details of the first gate electrode 615 are substantially the same as those of the first gate electrode 115 in the above-described embodiment, detailed descriptions thereof will be omitted.

A first interlayer insulating layer ILD1 may be disposed to insulate (or to be disposed) between the first gate electrode 615 and the first and second connection electrodes 616 and 617. Further details of the first interlayer insulating layer ILD1 are substantially the same as those of the first interlayer insulating layer ILD1 in the above-described embodiment, and thus detailed descriptions thereof will be omitted.

The first connection electrode 616 and the second connection electrode 617 may be disposed on the first interlayer insulating layer ILD1. Further details of the first connection electrode 616 and the second connection electrode 617 are substantially the same as those of the first connection electrode 116 and the second connection electrode 117 in the above-described embodiment, and thus detailed descriptions thereof will be omitted.

The second thin-film transistor 620 may be disposed above the first thin-film transistor 610. For example, a second interlayer insulating layer ILD2 may be formed on the first interlayer insulating layer ILD1, and the second thin-film transistor 620 may be formed on the second interlayer insulating layer ILD2.

For example, the second interlayer insulating layer ILD2 may be formed to cover the first thin-film transistor 610. Further details of the second interlayer insulating layer ILD2 are substantially the same as those described in the above-described embodiment, and thus detailed descriptions thereof will be omitted.

The second thin-film transistor 620 may include the second active layer 623 and a second gate electrode 625.

The second thin-film transistor 620 may further include a third connection electrode 626 and a fourth connection electrode 627.

The second active layer 623 may be disposed on the second interlayer insulating layer ILD2.

The second active layer 623 may include an oxide semiconductor.

For example, the second active layer 623 may include zinc oxide (ZnOₓ), gallium oxide (GaOₓ), titanium oxide (TiOₓ), indium oxide (InOₓ), indium-gallium oxide (IGO), indium-zinc oxide (IZO), gallium-zinc oxide (GZO), zinc-magnesium oxide (ZMO), zinc-zirconium oxide (ZnZrₓO_{y}), indium-gallium-zinc oxide (IGZO), and indium-gallium-hafnium oxide (IGHO), and these oxides may be used alone or in combination with each other.

For example, the second active layer 623 may include indium-tin-gallium-zinc oxide (ITGZO).

In the embodiment, the second active layer 623 may be formed to have properties different from those of the first active layer 613. For example, the electrical properties of the second active layer 623 may be different from the electrical properties of the first active layer 613.

For example, the first active layer 613 and the second active layer 623 may be different from each other in electron mobility. For example, the electron mobility of the first active layer 613 may be higher than the electron mobility of the second active layer 623. Various methods may be used to achieve these shared properties, and the oxide material of the first active layer 613 may be different from the oxide material of the second active layer 623. For example, the first active layer 613 may include indium-tin-gallium-zinc oxide (ITGZO), and the second active layer 623 may include indium-gallium-zinc oxide (IGZO). In another embodiment, the materials of the first active layer 613 and the second active layer 623 may be selected through various combinations of oxides to create a difference in electron mobility.

As another example of various methods to achieve these shared properties, the oxide material of the first active layer 613 and the oxide material of the second active layer 623 may be made the same. For example, the first active layer 613 and the second active layer 623 may include indium-gallium-zinc oxide (IGZO), and the electron mobilities of the first active layer 613 and the second active layer 623 may be made different by adjusting the amount of hydrogen diffusion or by using dopants. For example, the electron mobility of the first active layer 613 may be made higher than that of the second active layer 623.

Through this, the efficient arrangement of the first thin-film transistor 610 and the second thin-film transistor 620, which are areas for signal generation in a pixel area or a driving circuit part area, may be readily implemented. For example, in the driving circuit part area, one driving circuit part (e.g., a buffer circuit part) that requires a relatively larger area or generates a larger number of signals may be formed using the first thin-film transistor 610, which includes the first active layer 613 with higher electron mobility. On top of the driving circuit part area, one driving circuit part (e.g., a light emission signal control circuit part) that occupies a relatively smaller area may be formed using the second thin-film transistor 620, which includes the second active layer 623 with lower electron mobility. The design efficiency of each area may be enhanced through the vertically stacked structure of thin-film transistors. As a result, high integration and high resolution of the display apparatus 600 may be readily implemented.

Meanwhile, in another embodiment, the opposite structure may be applied, where the first active layer 613 and the second active layer 623 may be different from each other in electron mobility, and for example, the electron mobility of the first active layer 613 may be lower than that of the second active layer 623, and the each of characteristics of the first active layer 613 and the second active layer 623 may be selected based on the design conditions of the display apparatus 600.

The second active layer 623 may at least partially overlap the first active layer 613, and for example, the second active layer 623 may entirely overlap the first active layer 613. As another example, the second active layer 623 may not overlap the first active layer 613 as illustrated with reference to FIG. 3 of the above-described embodiment.

The second gate electrode 625 may overlap the second active layer 623, and for example, may be disposed above the second active layer 623 in the thickness direction of the substrate 601.

A second gate insulating film 624 may be disposed to insulate (or to be disposed) between the second active layer 623 and the second gate electrode 625.

Further details of the second gate insulating film 624 are substantially the same as those of the second gate insulating film 124 in the above-described embodiment, and thus detailed descriptions thereof will be omitted.

The second gate electrode 625 may be disposed on the second gate insulating film 624. The second gate electrode 625 may overlap the second active layer 623, for example, to be in contact with the second gate insulating film 624.

Further details of the second gate electrode 625 are substantially the same as those of the second gate electrode 125 in the above-described embodiment, and thus detailed descriptions thereof will be omitted.

A third interlayer insulating layer ILD3 may be disposed to insulate (or to be disposed) between the second gate electrode 625 and the third and fourth connection electrode 626 and 627. For example, the third interlayer insulating layer ILD3 may be formed on top of the second gate electrode 625 and the second active layer 623 to cover the second gate electrode 625 and the second active layer 623. Further details of the third interlayer insulating layer ILD3 are substantially the same as those of the third interlayer insulating layer ILD3 in the above-described embodiment, and thus detailed descriptions thereof will be omitted.

The third connection electrode 626 and the fourth connection electrode 627 may be disposed on the third interlayer insulating layer ILD3. Further details of the third connection electrode 626 and the fourth connection electrode 627 are substantially the same as those of the third connection electrode 126 and the fourth connection electrode 127 in the above-described embodiment, and thus detailed descriptions thereof will be omitted.

In the display apparatus 600 of the embodiment, the first thin-film transistor 610 may be disposed on the substrate 601, and the second thin-film transistor 620 may be disposed above the first thin-film transistor 610. The second active layer 623 including the oxide of the second thin-film transistor 620 may be disposed above the first active layer 613 including the oxide of the first thin-film transistor 610.

Through this structure, by forming the first active layer 613 without using high-energy processes (e.g., laser crystallization) in case that forming the first thin-film transistor 610 disposed at a lower position in the thickness direction of the substrate 601, and similarly forming the second active layer 623 without using high-energy processes (e.g., laser crystallization) in case that forming the second thin-film transistor 620 disposed at a higher position, thermal damage to the first thin-film transistor 610 located in the lower position can be reduced or prevented. It is possible to reduce or prevent the occurrence of stains on the first active layer 613 and the second active layer 623 during the high-energy processes (e.g., laser crystallization).

Through this process, it is possible to readily and safely form a structure in which the second thin-film transistor 620 is disposed above the first thin-film transistor 610, i.e., a structure in which multiple thin-film transistors are stacked. As a result, one or more circuits may be highly integrated and disposed, and a high resolution of the display apparatus 600 may be readily implemented.

In the embodiment, the second active layer 623 may be formed to have different properties from the first active layer 613. For example, the electrical properties of the second active layer 623 may be different from those of the first active layer 613. For example, the first active layer 613 and the second active layer 623 may be different from each other in electron mobility. For example, the electron mobility of the first active layer 613 may be higher than the electron mobility of the second active layer 623.

Through this, the efficient arrangement of the vertically stacked structure of the first thin-film transistor 610 and the second thin-film transistor 620 in the pixel area or the driving circuit part area may be readily implemented. For example, by arranging a thin-film transistor (e.g., the first thin-film transistor) capable of implementing high electron mobility in areas that require relatively more circuit placement or signal generation, and a thin-film transistor (e.g., the second thin-film transistor) capable of implementing low electron mobility in areas that require relatively less circuit placement or signal generation, the layout design characteristics between the upper and lower layers of each area of the display apparatus 600 may be precisely and readily controlled as needed.

The configuration in which the second active layer 623 and the first active layer 613 of the embodiment have different properties, such as different electrical properties, in with the various descriptions provided above regarding these layers, may be selectively applied to the embodiments described with reference to FIGS. 1 to 5, and may also be selectively applied to embodiments described later in this specification.

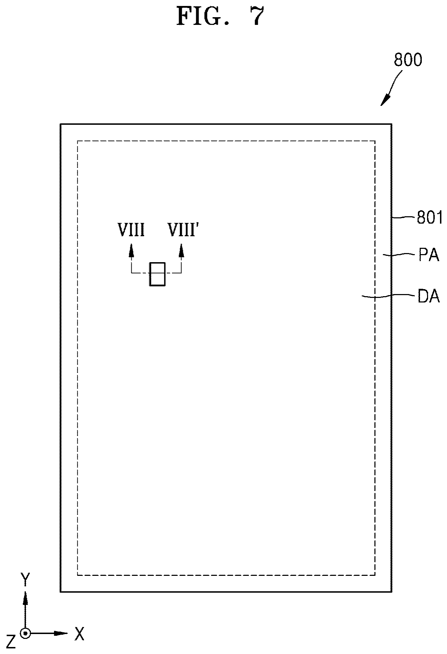

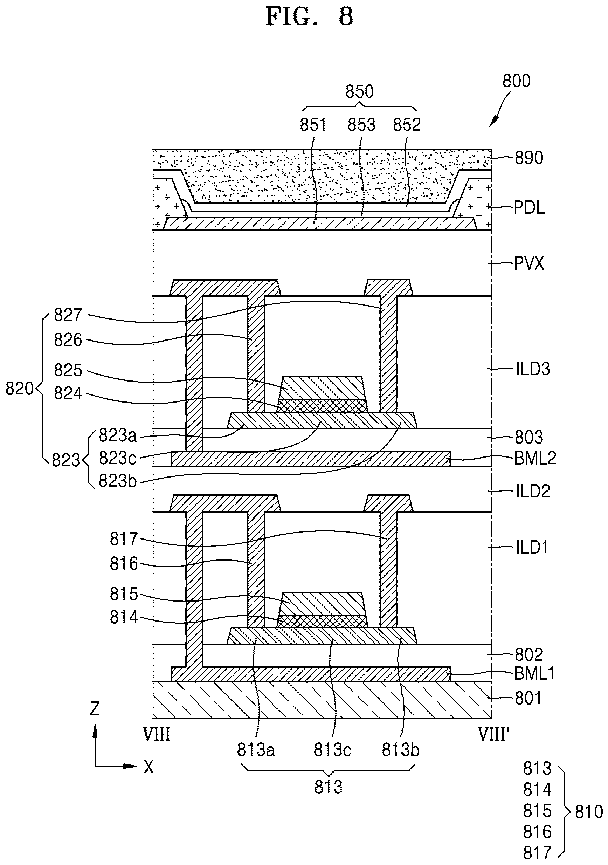

FIG. 7 is a schematic plan view illustrating a display apparatus according to another embodiment of the disclosure. FIG. 8 is a schematic cross-sectional view taken along line VIII-VIII' of FIG. 7.

A display apparatus 800 may include a display area DA and a peripheral area PA.

One or more display elements (not shown), such as organic light-emitting devices (OLEDs), may be provided in the display area DA to display an image. For example, the display element may include a quantum dot light-emitting element or a liquid crystal display element, and as another example, the display element may include one of various other types, such as a light-emitting diode (LED), a micro LED, a mini LED, or a nano LED.

Multiple pixels (not shown) may be disposed in the display area DA, and one or more display elements (not shown) may be disposed in the pixel (not shown).

The peripheral area PA may be formed around the display area DA. The peripheral area PA may include a non-display area (not shown), and for example, the non-display area may be formed to surround the display area DA. In another embodiment, the peripheral area PA or the non-display area of the peripheral area PA may be formed to be disposed adjacent to only one or both side surfaces of the display area DA.

A driving circuit part area that generates various signals for the operation of the pixels in the display area DA may be disposed in the peripheral area PA, and the driving circuit part area may have one or more driving circuit parts.

Referring to FIGS. 7 and 8, the display apparatus 800 may include a substrate 801, a first thin-film transistor 810, and a second thin-film transistor 820.

FIG. 8 may schematically illustrate at least one area of one pixel of the display apparatus 800. For example, one pixel of the display apparatus 800 may include the first thin-film transistor 810 and the second thin-film transistor 820.

Each of the first thin-film transistor 810 and the second thin-film transistor 820 may generate the same signal or different signals for the pixel to operate.

The configurations of the substrate 801, a buffer layer 802, and a first active layer 813, a first gate electrode 815, a first gate insulating film 814, a first connection electrode 816, and a second connection electrode 817 of the first thin-film transistor 810 are substantially the same as those of the above-described embodiments, such as the configurations of the substrate 101, the buffer layer 102, and the first active layer 113, the first gate electrode 115, the first gate insulating film 114, the first connection electrode 116, and the second connection electrode 117 of the first thin-film transistor 110 described in FIG. 1, and thus detailed descriptions thereof will be omitted. The first active layer 813 may include a first connection area 813a, a second connection area 813b, and a first channel region 813c disposed therebetween.

A first interlayer insulating layer ILD1, a second interlayer insulating layer ILD2, and a third interlayer insulating layer ILD3 are substantially the same as those described in the above-described embodiments, and thus detailed descriptions thereof will be omitted.

Configurations of a second active layer 823, a second gate electrode 825, a second gate insulating film 824, a third connection electrode 826 and a fourth connection electrode 827 of the second thin-film transistor 820 are substantially the same as those in the above-described embodiments, such as the second active layer 123, the second gate electrode 125, the second gate insulating film 124, the third connection electrode 126, the fourth connection electrode 127 of the second thin-film transistor 120 described in FIG. 1, and thus detailed descriptions thereof will be omitted. The second active layer 823 may include a first connection area 823a, a second connection area 823b, and a second channel region 823c disposed therebetween.

In another embodiment, an upper buffer layer 803, a first conductive pattern portion BML1, and a second conductive pattern portion BML2 may be further disposed, which are substantially the same as those in the embodiment described above with reference to FIG. 4, and thus detailed descriptions thereof will be omitted.

Although not shown in the drawing, it is possible to apply at least one of the structures of FIGS. 2 to 6 to the display apparatus 800 of the embodiment.

A protective insulating layer PVX may be disposed on top of the second thin-film transistor 820, and may be disposed, for example, to cover the second thin-film transistor 820.

The protective insulating layer PVX may contain an insulating material to protect and insulate the second thin-film transistor 820.

In another embodiment, the protective insulating layer PVX may eliminate a step caused by the second thin-film transistor 820 and provide a flat surface over the second thin-film transistor 820, thereby reducing or preventing defects in a display element 850 caused by underlying unevenness.

The protective insulating layer PVX may be formed of various materials, and may be formed using organic or inorganic materials alone or in combination. The protective insulating layer PVX may include a single layer or multilayer including organic materials. For example, the protective insulating layer PVX may include a composite laminate of an inorganic insulating film and an organic insulating film.

The display element 850 may be disposed on top of the protective insulating layer PVX. As described above, the display element 850 may be one of various types, such as an organic light-emitting element, which will be used as an example in the following description.

Although not shown in the drawing, the display element 850 may be electrically connected to an underlying circuit, such as the first thin-film transistor 810 or the second thin-film transistor 820.

The display element 850 may include a first electrode 851, a second electrode 852, and an intermediate layer 853 interposed therebetween.

The first electrode 851 may be electrically connected to an underlying circuit, such as the first thin-film transistor 810 or the second thin-film transistor 820.

The first electrode 851 may have various shapes and, for example, may be patterned into an island shape.

The first electrode 851 may contain various conductive materials. For example, the first electrode 851 may include at least one selected from the group of transparent conductive oxides, such as indium tin oxide (ITO), indium zinc oxide (IZO), zinc oxide (ZnO), indium oxide (In₂O₃), indium gallium oxide (IGO), and aluminum zinc oxide (AZO). The first electrode 851 may include a highly reflective metal, such as silver (Ag).

The intermediate layer 853 may include an organic light-emitting layer, and the organic light-emitting layer may use a low-molecular-weight organic material or a high-molecular-weight organic material. In another embodiment, the intermediate layer 853 may further include, in addition to the organic light-emitting layer, at least one selected from the group consisting of a hole injection layer, a hole transport layer, an electron transport layer, and an electron injection layer.

Meanwhile, the organic light-emitting layer may be formed separately for each organic light-emitting element. For example, each of organic light-emitting elements may emit red, green, and blue light. However, the disclosure is not limited thereto, and the organic light-emitting layer may be formed commonly over the entire organic light-emitting element. For example, multiple organic light-emitting layers emitting red, green, and blue light may be vertically stacked or mixed to produce white light. Of course, the combination of colors for emitting white light is not limited to those described above. Meanwhile, for example, a color conversion layer or a color filter that converts the emitted white light into a predetermined color may be provided separately.

The second electrode 852 may be formed of various conductive materials. For example, the second electrode 852 may contain lithium (Li), calcium (Ca), lithium fluoride (LiF), aluminum (Al), magnesium (Mg), or silver (Ag), may be formed as a single layer or multilayer using at least one of the above materials, and may also include an alloy material including at least two of the above materials.

A pixel defining film PDL may be disposed on the protective insulating layer PVX so as not to cover a predetermined area of the first electrode 851. Thereafter, the intermediate layer 853 may be disposed on an area of the first electrode 851 that is not covered by the pixel defining film PDL, and the second electrode 852 may be disposed on the intermediate layer 853.

The pixel defining film PDL may be formed of various insulating materials. For example, the pixel defining film PDL may contain an organic material, and for example, may be formed by a method such as spin coating using one or more organic insulating materials selected from the group consisting of polyimide, polyamide, acrylic resin, benzocyclobutene, and phenol resin.

In another embodiment, one or more functional layers (not shown) may be further disposed on the second electrode 852, and for example, at least one layer of the functional layers may reduce contamination of the second electrode 852 during subsequent processes, and another layer of the functional layers may improve the efficiency of visible light extracted from the intermediate layer 853.

An encapsulation portion 890 may be disposed to protect the display element 850. For example, the encapsulation portion 890 with one or more encapsulation layers may be disposed on the second electrode 852 to block or reduce the penetration of moisture or other foreign substances into the display element 850.

For example, the encapsulation portion 890 may have two or more, or four or more encapsulation layers. In another embodiment, the encapsulation portion 890 may include one or more inorganic layers or one or more organic layers. For example, the encapsulation portion 890 may have a structure in which inorganic layers and organic layers are alternately stacked at least once, or for example, stacked multiple times.

In the display apparatus 800 of the embodiment, the first thin-film transistor 810 may be disposed on the substrate 801, and the second thin-film transistor 820 may be disposed above the first thin-film transistor 810. The second active layer 823 including the oxide of the second thin-film transistor 820 may be disposed above the first active layer 813 including the oxide of the first thin-film transistor 810.

Through this structure, by forming the first active layer 813 without using high-energy processes (e.g., laser crystallization) in case that forming the first thin-film transistor 810 disposed at a lower position in a thickness direction of the substrate 801, and similarly forming the second active layer 823 without using high-energy processes (e.g., laser crystallization) in case that forming the second thin-film transistor 820 disposed at a higher position, thermal damage to the first thin-film transistor 810 located in the lower position can be reduced or prevented. It is possible to reduce or prevent the occurrence of stains on the first active layer 813 and the second active layer 823 during the high-energy processes (e.g., laser crystallization).

Multiple thin-film transistors included in one pixel of the display apparatus 800 may include active layers including oxides, and these thin-film transistors may be disposed vertically with respect to the substrate 801. This configuration enables easy dense integration of circuits within the pixel, thereby facilitating the implementation of a high resolution of the display apparatus 800.

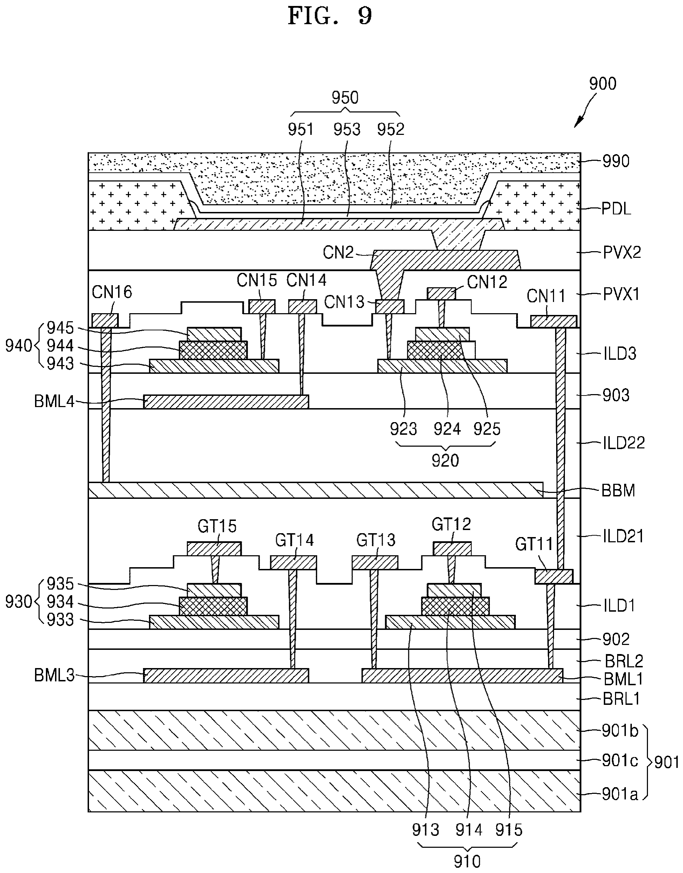

FIG. 9 is a schematic cross-sectional view illustrating a display apparatus according to another embodiment of the disclosure.

For convenience of description, differences from the display apparatus 800 of FIG. 8 will be mainly described.

A display apparatus 900 may include a substrate 901, a first thin-film transistor 910, a second thin-film transistor 920, a third thin-film transistor 930, and a fourth thin-film transistor 940.

FIG. 9 may be a view schematically illustrating at least one area of one pixel of the display apparatus 900. For example, one pixel of the display apparatus 900 may include the first thin-film transistor 910, the second thin-film transistor 920, the third thin-film transistor 930, and the fourth thin-film transistor 940.

Each of the first thin-film transistor 910, the second thin-film transistor 920, the third thin-film transistor 930, and the fourth thin-film transistor 940 may generate the same signal or different signals for the pixel to operate.

Each of the first thin-film transistor 910, the second thin-film transistor 920, the third thin-film transistor 930, and the fourth thin-film transistor 940 may include an active layer including an oxide, and may respectively include, for example, a first active layer 913, a second active layer 923, a third active layer 933, and a fourth active layer 943, each including an oxide.

A distance between the substrate 901 and the first thin-film transistor 910 may have a smaller value than that between the substrate 901 and the second thin-film transistor 920. Based on a thickness direction of the substrate 901 (e.g., a Z-axis direction in FIG. 9), the first thin-film transistor 910 may be disposed between the substrate 901 and the second thin-film transistor 920.

A distance between the substrate 901 and the third thin-film transistor 930 may have a smaller value than that between the substrate 901 and the fourth thin-film transistor 940. Based on the thickness direction of the substrate 901 (e.g., the Z-axis direction in FIG. 9), the third thin-film transistor 930 may be disposed between the substrate 901 and the fourth thin-film transistor 940.

In another embodiment, the first active layer 913 of the first thin-film transistor 910 and the third active layer 933 of the third thin-film transistor 930 may be formed at a same layer (e.g., on a buffer layer 902). For example, the first active layer 913 and the third active layer 933 may be formed simultaneously using the same oxide material.

In another embodiment, the second active layer 923 of the second thin-film transistor 920 and the fourth active layer 943 of the fourth thin-film transistor 940 may be formed at a same layer (e.g., on an upper buffer layer 903). For example, the second active layer 923 and the fourth active layer 943 may be formed simultaneously using the same oxide material.

The substrate 901 may include one of various shapes and various materials. For example, the substrate 901 may include multiple layers, and may include one or more organic layers (e.g., resin-based materials) and one or more inorganic layers. For example, the substrate 901 may include two organic layers (e.g., a first organic layer 901a and a second organic layer 901b) and an inorganic layer 901c disposed between the two organic layers.

In another embodiment, one or more barrier layers BRL1 and BRL2 may be disposed between the substrate 901 and the buffer layer 902. The one or more barrier layers BRL1 and BRL2 may include a first barrier layer BRL1 and a second barrier layer BRL2.

The barrier layers BRL1 and BRL2 may reduce or prevent the inflow of foreign substances from the outside and may contain an insulating material, and for example may include a single layer or stacked structure of an inorganic material such as a silicon oxide layer and a silicon nitride layer.

In another embodiment, a first conductive pattern portion BML1 and a third conductive pattern portion BML3 may be disposed between the first barrier layer BRL1 and the second barrier layer BRL2.

An intermediate conductive layer BBM may be disposed between the first and third thin-film transistors 910 and 930 and the second and fourth thin-film transistor 920 and 940. The intermediate conductive layer BBM may be disposed between insulating layers, for example, between a lower layer ILD21 and an upper layer ILD22 of a second interlayer insulating layer.

The configurations of the first active layer 913, a first gate electrode 915, and a first gate insulating film 914 of the first thin-film transistor 910 may be modified and applied within a range substantially the same as or similar to those of one of the above-described embodiments, and optionally, a first connection electrode (not shown) or a second connection electrode (not shown) may be further disposed.

The configurations of the second active layer 923, a second gate electrode 925, and a second gate insulating film 924 of the second thin-film transistor 920 may be modified and applied within a range substantially the same as or similar to those of one of the above-described embodiments, and optionally, a first connection electrode or a second connection electrode (not shown) may be further disposed.

The configurations of the third active layer 933, a third gate electrode 935, and a third gate insulating film 934 of the third thin-film transistor 930 may be modified and applied within a range identical to or similar those of one of the first thin-film transistors described in the above-described embodiments, and optionally, a first connection electrode (not shown) or a second connection electrode (not shown) may be further disposed.

The configurations of the fourth active layer 943, a fourth gate electrode 945, and a fourth gate insulating film 944 of the fourth thin-film transistor 940 may be modified and applied within a range identical to or similar to those of one of the second thin-film transistors described in the above-described embodiments, and optionally, a first connection electrode (not shown) or a second connection electrode (not shown) may be further disposed.

In the drawing, the first conductive pattern portion BML1, the third conductive pattern portion BML3, and a fourth conductive pattern portion BML4 are illustrated, but these are examples, and a second conductive pattern portion (not shown) may also be included to correspond to the second thin-film transistor 920.

For example, at least one or all of the first conductive pattern portion BML1, the third conductive pattern portion BML3, and the fourth conductive pattern portion BML4 may be omitted.

The buffer layer 902, the upper buffer layer 903, a first interlayer insulating layer ILD1, a second interlayer insulating layer ILD21(ILD22), a third interlayer insulating layer ILD3, and the like are substantially the same as those described in the above-described embodiments, and thus detailed descriptions thereof will be omitted.

In another embodiment, one or more lower conductive connection patterns GT11, GT12, GT13, GT14, and GT15 may be disposed above the first thin-film transistor 910 and the third thin-film transistor 930. The lower conductive connection patterns GT11, GT12, GT13, GT14, and GT15 may be electrically connected to one area of each of the first and third thin-film transistors 910 and 930 and the first and third conductive pattern portions BML1 and BML3 located below the first and third thin-film transistors 910 and 930, respectively, and for example, may be electrically connected thereto through contact holes passing through at least one of the buffer layer 902, the second barrier layer BRL2, and the first interlayer insulating layer ILD1.

In another embodiment, one or more upper conductive connection patterns CN11, CN12, CN13, CN14, CN15, and CN16 may be disposed above the second thin-film transistor 920 and the fourth thin-film transistor 940. The upper conductive connection patterns CN11, CN12, CN13, CN14, CN15, and CN16 may be electrically connected to one area of each of the second and fourth thin-film transistors 920 and 940 and the fourth conductive pattern portion BML4 located below the fourth thin-film transistor 940, respectively, and for example, may be electrically connected thereto through contact holes passing through at least one of the upper buffer layer 903 and the third interlayer insulating layer ILD3.

In another embodiment, one or more (e.g., CN11) of the upper conductive connection patterns CN11, CN12, CN13, CN14, CN15, and CN16 may be electrically connected to one (e.g., GT11) of the lower conductive connection patterns GT11, GT12, GT13, GT14, and GT15.

In another embodiment, one or more (e.g., CN16) of the upper conductive connection patterns CN11, CN12, CN13, CN14, CN15, and CN16 may be electrically connected to the intermediate conductive layer BBM.

A first protective insulating layer PVX1 may be disposed above the second thin-film transistor 920 and the fourth thin-film transistor 940, for example, to cover the second thin-film transistor 920 and the fourth thin-film transistor 940.

The first protective insulating layer PVX1 may contain an insulating material to protect and insulate the second thin-film transistor 920 and the fourth thin-film transistor 940.

In another embodiment, a second protective insulating layer PVX2 may be formed on the first protective insulating layer PVX1.

In another embodiment, a second upper conductive connection pattern CN2 may be disposed on the first protective insulating layer PVX1. At this time, the second upper conductive connection pattern CN2 may be electrically connected to one or more (e.g., CN13) of the upper conductive connection patterns CN11, CN12, CN13, CN14, CN15, and CN16 and may be electrically connected to a first electrode 951 of a display element 950.

The display element 950 may be disposed on top of the second protective insulating layer PVX2. For example, the display element 950 may include an organic light-emitting element, and may be electrically connected to an underlying circuit, for example, one (e.g., the second thin-film transistor) of the first to fourth thin-film transistors 910, 920, 930, and 940.

The display element 950 may include the first electrode 951, a second electrode 952, and an intermediate layer 953 interposed therebetween, and details thereof are substantially the same as those described in the display element 850 in the above-described embodiment, and thus detailed descriptions thereof will be omitted.

A pixel defining film PDL may be disposed on the second protective insulating layer PVX2 so as not to cover a predetermined area of the first electrode 951. Thereafter the intermediate layer 953 may be disposed on an area of the first electrode 951 that is not covered by the pixel defining film PDL, and the second electrode 952 may be disposed on the intermediate layer 953.

An encapsulation portion 990 may be disposed to protect the display element 950, and is substantially the same as that described in the above-described embodiment, and thus detailed descriptions thereof will be omitted.

In the display apparatus 900 of the embodiment, the first thin-film transistor 910 and the third thin-film transistor 930 may be disposed above the substrate 901, and the second thin-film transistor 920 and the fourth thin-film transistor 940 may be disposed above the first thin-film transistor 910 and the third thin-film transistor 930.

Each of the first thin-film transistor 910, the third thin-film transistor 930, the second thin-film transistor 920, and the fourth thin-film transistor 940 may have an active layer including an oxide.

Although not shown in the drawing, a single pixel may include five or more (e.g., six or seven or more) thin-film transistors, which may be disposed in a stacked form in the lower and upper layer regions in the thickness direction of the substrate.

Through this structure, by forming the first active layer 913 and the third active layer 933 without using high-energy processes (e.g., laser crystallization) in case that forming the first thin-film transistor 910 and the third thin-film transistor 930 disposed at a lower position in the thickness direction of the substrate 901, and similarly forming the second active layer 923 and the fourth active layer 943 without using high-energy processes (e.g., laser crystallization) in case that forming the second thin-film transistor 920 and the fourth thin-film transistor 940 disposed at a higher position, thermal damage to the underlying first and third thin-film transistors 910 and 930 can be reduced or prevented. It is possible to reduce or prevent the occurrence of stains on the first active layer 913, the second active layer 923, the third active layer 933, and the fourth active layer 943 during the high-energy processes (e.g., laser crystallization).

Each of multiple thin-film transistors included in one pixel of the display apparatus 900 may include an active layer including an oxide, and at least two or more of these thin-film transistors may be disposed at a same layer with respect to the substrate 901. Multiple thin-film transistors may be disposed in the form of a two-layer vertically stacked structure. This configuration can reduce the expansion of the pixel area, even in cases where the circuit included in the pixel becomes more complex, for example, in case that the number of thin-film transistors increases, thereby facilitating the implementation of high resolution in the display apparatus 900.

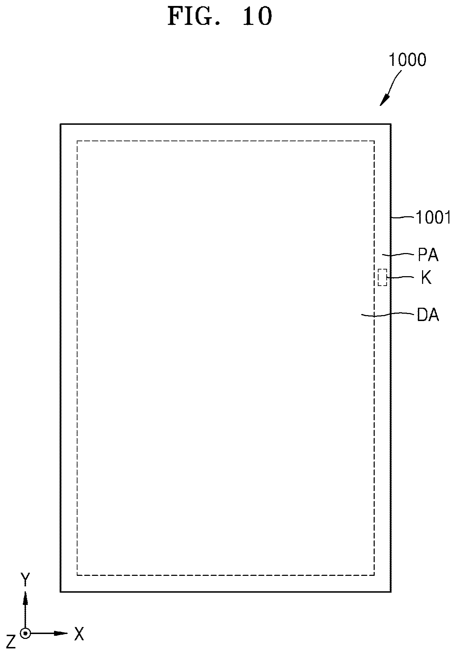

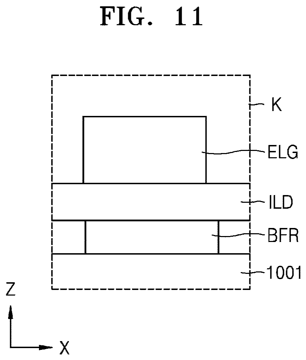

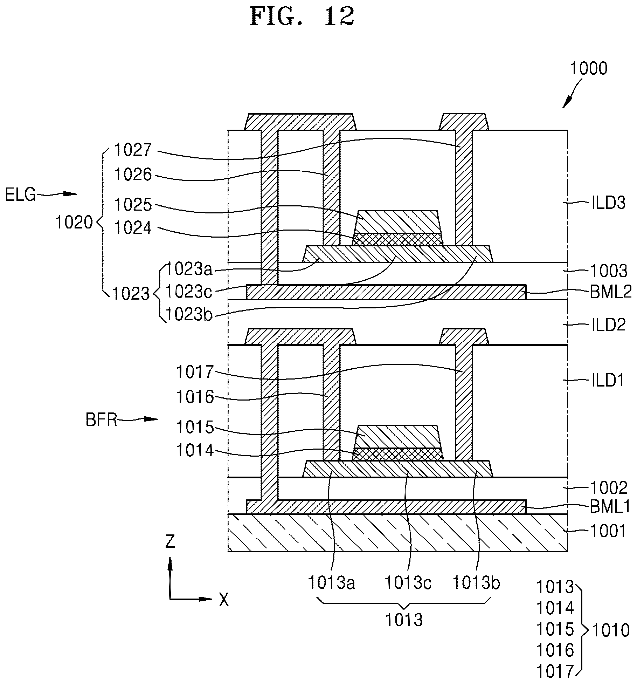

FIG. 10 is a schematic plan view illustrating a display apparatus according to another embodiment of the disclosure. FIG. 11 is a schematic cross-sectional view for describing area K of FIG. 10. FIG. 12 is a schematic view illustrating an example of the structure of FIG. 11.

A display apparatus 1000 may include a display area DA and a peripheral area PA.

One or more display elements (not shown), such as organic light-emitting devices (OLEDs), may be provided in the display area DA to display an image. For example, the display element may include a quantum dot light-emitting element or a liquid crystal display element, and as another example, the display element may include one of various other types, such as a light-emitting diode (LED), a micro LED, a mini LED, or a nano LED.

The display element may include one of several other types.

Multiple pixels (not shown) may be disposed in the display area DA, and one or more display elements (not shown) may be disposed in the pixel (not shown).

The peripheral area PA may be formed around the display area DA. The peripheral area PA may include a non-display area (not shown), and as an example, the non-display area may be formed to surround the display area DA. In another embodiment, the peripheral area PA or the non-display area of the peripheral area PA may be formed to be disposed adjacent to only one or both side surfaces of the display area DA.

A driving circuit part area that generates various signals for the operation of the pixels in the display area DA may be disposed in the peripheral area PA, and the driving circuit part area may have one or more driving circuit parts.

For example, multiple driving circuit parts, i.e., multiple different types of driving circuit parts, may be disposed in the peripheral area PA.

Referring to FIG. 11, two different types of driving circuit parts BFR and ELG may be disposed on a substrate 1001, and may be disposed on upper and lower layers in a thickness direction of the substrate 1001, respectively. For example, the driving circuit parts BFR and ELG may be disposed on lower and upper portions, respectively, with an interlayer insulating film ILD interposed therebetween.

In another embodiment, a buffer circuit part BFR and a light emission control circuit part ELG may be disposed on the lower and upper layers, respectively, with the interlayer insulating film ILD interposed therebetween. This is for illustrative purposes only and various types of driving circuit parts may be selectively disposed.

The buffer circuit part BFR may be disposed to implement various functions, and for example, may be included in a shift register that sequentially shifts scan output signals based on a clock signal.

Referring to FIG. 12, a first thin-film transistor 1010 and a second thin-film transistor 1020 disposed on the substrate 1001 are illustrated.

The buffer circuit part BFR may include the first thin-film transistor 1010. For example, the buffer circuit part BFR may include the first thin-film transistor 1010, which includes a first active layer 1013 including an oxide. In another embodiment, the buffer circuit part BFR may include multiple first thin-film transistors 1010, which are multiple first thin-film transistors 1010 that may be disposed side by side on the same layer.

The light emission control circuit part ELG may include the second thin-film transistor 1020. For example, the light emission control circuit part ELG may include the second thin-film transistor 1020, which includes a second active layer 1023 including an oxide. In another embodiment, the light emission control circuit part ELG may include multiple second thin-film transistors 1020, which are multiple second thin-film transistors 1020 may be disposed side by side on the same layer. The first active layer 1013 may include a first connection area 1013a, a second connection area 1013b, and a first channel region 1013c disposed therebetween. The second active layer 1023 may include a first connection area 1023a, a second connection area 1023b, and a second channel region 1023c disposed therebetween.

The configurations of a buffer layer 1002, a first gate electrode 1015, a first gate insulating film 1014, a first connection electrode 1016, and a second connection electrode 1017, a first interlayer insulating layer ILD1, a second interlayer insulating layer ILD2, a third interlayer insulating layer ILD3, a second gate electrode 1025, a second gate insulating film 1024, a third connection electrode 1026 and a fourth connection electrode 1027 may be modified and applied within a range substantially the same as or similar to those described in the above-described embodiments, and thus detailed descriptions thereof will be omitted.

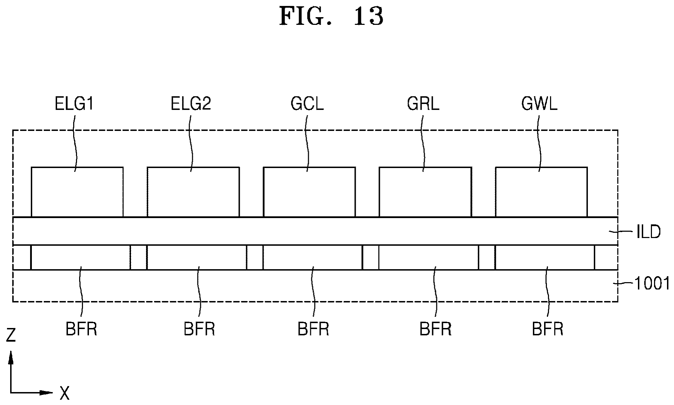

FIG. 13 is a schematic view illustrating one modified example of FIG. 11.

Referring to FIG. 13, two or more driving circuit parts BFR, ELG1, ELG2, GCL, GRL, and GWL of different types may be disposed on the substrate 1001, and may be disposed on upper and lower layers based on the thickness direction of the substrate 1001, for example, such that multiple parts are disposed on the lower layer and multiple parts are disposed on the upper layer, with the interlayer insulating film ILD interposed between the upper and lower layers.

In another embodiment, multiple buffer circuit parts BFRs may be disposed on the lower layer, and other types of circuit parts, such as a first light emission control circuit part ELG1, a second light emission control circuit part ELG2, a first scan control circuit part GCL, a second scan control circuit part GRL, and a third scan control circuit part GWL, may be disposed on the upper layer, with the interlayer insulating film ILD interposed between the upper and lower layers. Each of the first scan control circuit part GCL, the second scan control circuit part GRL, and the third scan control circuit part GWL may output or control different scan signals, and may include a start scan signal control part, a reference scan signal control part, and a write scan signal control part, and may further include a compensation scan signal control part or an initialization scan signal control part.

This is for illustrative purposes only and various types of driving circuit parts may be selectively disposed.

The specific structure of FIG. 12 may also be applied to the embodiment of FIG. 13.

For example, multiple first thin-film transistors 1010 may be disposed to correspond to multiple buffer circuit parts BFRs.

After an interlayer insulating film ILD is disposed on top of multiple first thin-film transistors 1010, multiple second thin-film transistors 1020 corresponding to the first light emission control circuit part ELG1, the second light emission control circuit part ELG2, the first scan control circuit part GCL, the second scan control circuit part GRL, and the third scan control circuit part GWL may be disposed.

One or more types of driving circuit parts may be disposed on the upper and lower layers on the substrate 1001 to correspond to one or more or multiple driving circuit parts disposed in the peripheral area PA of the display apparatus 1000 of the embodiment. For example, one or more types of driving circuit parts may be disposed on the upper portion, and one or more different types of driving circuit parts may be disposed on the lower portion, with the interlayer insulating film ILD interposed between the upper and lower portions. The first thin-film transistors 1010 and the second thin-film transistors 1020 may be disposed to correspond to the driving circuit parts.

By arranging one or more first thin-film transistors and one or more second thin-film transistors to overlap in at least one area in the thickness direction of the substrate, multiple driving circuit parts can be readily disposed to overlap in the thickness direction of the substrate, corresponding thereto.

Through this, the area of the peripheral area PA may be reduced, the high integration of the driving circuit parts may be readily achieved, and the manufacturability of the high-resolution display apparatus 1000 may be improved.

Meanwhile, in another embodiment, in the case of a buffer circuit, which occupies a relatively large area among the driving circuit parts, a circuit part formation area can be reduced by arranging the first thin-film transistor 1010 with a first active layer 1013 that has a higher electron mobility than a second active layer 1023 of the second thin-film transistor 1020. Through this, the effect of reducing the peripheral area PA can be further enhanced. It can be determined whether to use identical active layers or those with different electrical properties, such as varying electron mobility, based on the characteristics of the different types of driving circuit parts and the number or area.

In case that these various types of driving circuit parts are stacked, all of the thin-film transistors in the driving circuit parts include active layers including oxides. This ensures thermal stability during manufacturing and reduces or prevents active layer streaks, thereby improving uniformity among multiple thin-film transistors.

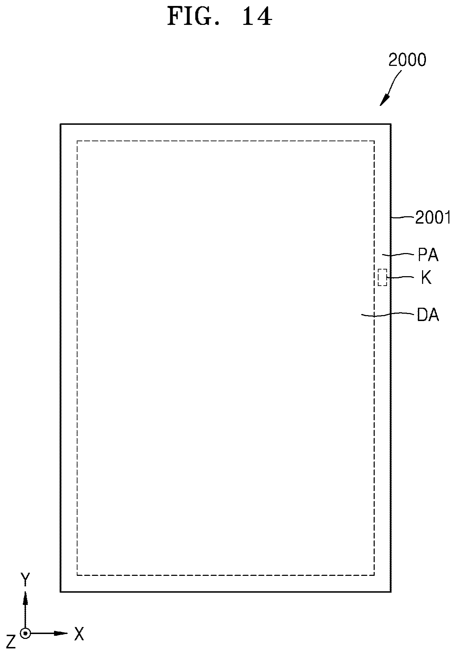

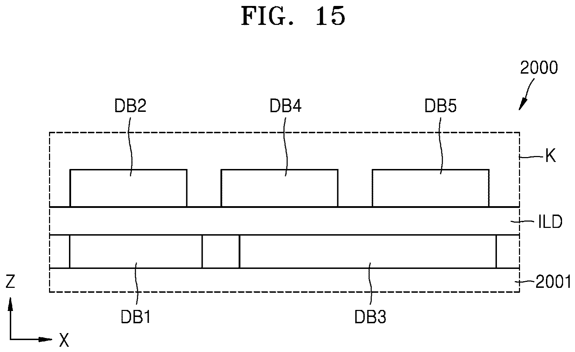

FIG. 14 is a schematic plan view illustrating a display apparatus according to another embodiment of the disclosure. FIG. 15 is a schematic cross-sectional view for describing area K of FIG. 14.

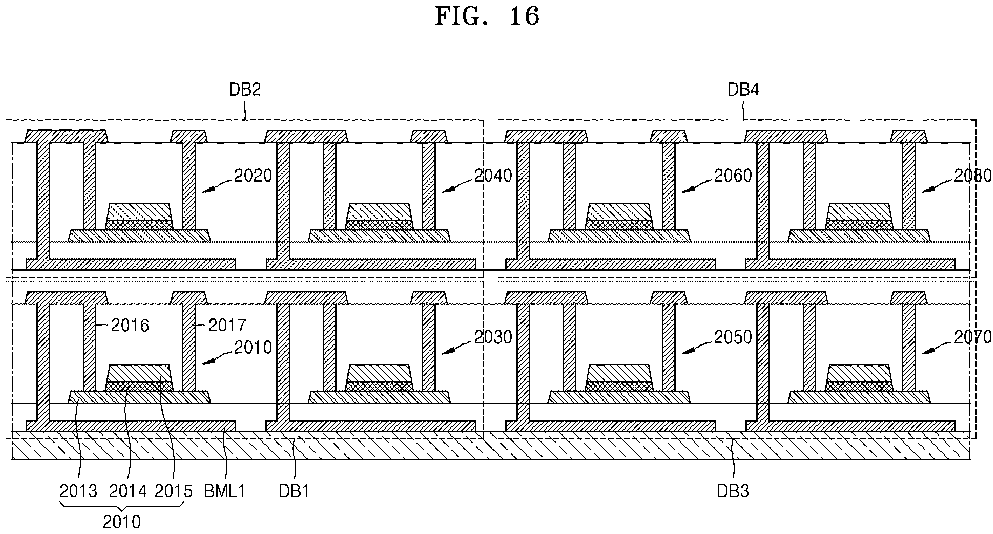

FIG. 16 is a schematic view illustrating an example of the structure of FIG. 15. For convenience of description, differences from the above-described embodiment will be mainly described.

A display apparatus 2000 may include a display area DA and a peripheral area PA.

The peripheral area PA may be formed around the display area DA.

A driving circuit part area that generates various signals for the operation of the pixels in the display area DA may be disposed in the peripheral area PA, and the driving circuit part area may include one or more driving circuit parts.

For example, multiple driving circuit parts, i.e., multiple different types of driving circuit parts, may be disposed in the peripheral area PA.

Referring to FIG. 15, two or more driving circuit part areas DB1, DB2, DB3, DB4, and DB5 of different types may be disposed on a substrate 2001, and may be disposed on upper and lower layers based on a thickness direction of the substrate 2001, for example, such that multiple areas are disposed on the lower portion and multiple areas are disposed on the upper portion, with an interlayer insulating film ILD interposed between the upper and lower portions.

In another embodiment, a first driving circuit part area DB1 and a third driving circuit part area DB3 may be disposed on the lower layer and a second driving circuit part area DB2, a fourth driving circuit part area DB4, and a fifth driving circuit part area DB5 may be disposed on the upper layer, with the interlayer insulating film ILD interposed between the upper and lower layers,

As shown in the drawings, the first driving circuit part area DB1 and the third driving circuit part area DB3 on the lower layer may overlap in at least one area with the second driving circuit part area DB2, the fourth driving circuit part area DB4, and the fifth driving circuit part area DB5 on the upper layer.

Each of the two or more driving circuit part areas DB1, DB2, DB3, DB4, and DB5 may include multiple driving circuit parts of one or more types.

For example, the first driving circuit part area DB1 may include one or more buffer circuit parts and a first scan control circuit part, the second driving circuit part area DB2 may include one or more buffer circuit parts and a first light emission control circuit part, the third driving circuit part area DB3 may include one or more buffer circuit parts and a third scan control circuit part, the fourth driving circuit part area DB4 may include one or more buffer circuit parts and a second light emission control circuit part, and the fifth driving circuit part area DB5 may include one or more buffer circuit parts and a second scan control circuit part.

Here, each of the first scan control circuit part, the second scan control circuit part, and the third scan control circuit part may output or control different scan signals, and may include a start scan signal control part, a reference scan signal control part, and a write scan signal control part, and may further include a compensation scan signal control part or an initialization scan signal control part.

Referring to FIG. 16, first to eighth thin-film transistors 2010 to 2080 disposed on the substrate 2001 are illustrated.

The first driving circuit part area DB1 may include the first thin-film transistor 2010 and the third thin-film transistor 2030. For example, the first driving circuit part area DB1 may include the first thin-film transistor 2010, which includes a first active layer 2013 including an oxide, and may also include the third thin-film transistor 2030, which includes a third active layer including an oxide. In another embodiment, the first thin-film transistor 2010 and the third thin-film transistor 2030 may be disposed side by side on the same layer.

The second driving circuit part area DB2 may include the second thin-film transistor 2020 and the fourth thin-film transistor 2040. For example, the second driving circuit part area DB2 may include the second thin-film transistor 2020, which includes a second active layer including an oxide, and may also include the fourth thin-film transistor 2040, which includes a fourth active layer including an oxide. In another embodiment, the second thin-film transistor 2020 and the fourth thin-film transistor 2040 may be disposed side by side on the same layer.

The second thin-film transistor 2020 and the fourth thin-film transistor 2040 may overlap in at least one area with the first thin-film transistor 2010 and the third thin-film transistor 2030, for example, each of the active layers of the upper and lower thin-film transistors may overlap each other.

The third driving circuit part area DB3 may include the fifth thin-film transistor 2050 and the seventh thin-film transistor 2070. For example, the third driving circuit part area DB3 may include the fifth thin-film transistor 2050, which includes a fifth active layer including an oxide, and may also include the seventh thin-film transistor 2070, which includes a seventh active layer including an oxide. In another embodiment, the fifth thin-film transistor 2050 and the seventh thin-film transistor 2070 may be disposed side by side on the same layer.

The fourth driving circuit part area DB4 may include the sixth thin-film transistor 2060 and the eighth thin-film transistor 2080. For example, the fourth driving circuit part area DB4 may include the sixth thin-film transistor 2060, which includes a sixth active layer including an oxide, and may also include the eighth thin-film transistor 2080, which includes an eighth active layer including an oxide. In another embodiment, the sixth thin-film transistor 2060 and the eighth thin-film transistor 2080 may be disposed side by side on the same layer.

The sixth thin-film transistor 2060 and the eighth thin-film transistor 2080 may overlap in at least one area with the fifth thin-film transistor 2050 and the seventh thin-film transistor 2070, for example, each of the active layers of the upper and lower thin-film transistors may overlap each other.

Although not shown in the drawing, the fifth driving circuit part area DB5 may include multiple thin-film transistors, each of which has an active layer including an oxide.

The configurations of a buffer layer, first to eighth gate electrodes (only "2015" is shown), first to eighth gate insulating films (only "2014" is shown), connection electrodes (only "2016" is shown), and connection electrodes (only "2017" is shown), a first interlayer insulating layer ILD1, a second interlayer insulating layer ILD2, and a third interlayer insulating layer ILD3 may be modified and applied within a range substantially the same as or similar to those described in the above-described embodiments, and thus detailed descriptions thereof will be omitted.

One or more types of driving circuit part areas may be disposed on the upper and lower layers on the substrate 2001 to correspond to one or more or multiple driving circuit part areas disposed in the peripheral area PA of the display apparatus 2000 of the embodiment. For example, one or more types of driving circuit parts may be disposed on the upper portion, and one or more different types of driving circuit parts may be disposed on the lower portion, with the interlayer insulating film ILD interposed between the upper and lower portions. Multiple thin-film transistors may be disposed to respectively correspond to the driving circuit parts.

At this time, in order to efficiently arrange multiple driving circuit parts, multiple areas may be defined in an upper layer and multiple areas may be defined in a lower layer with an interlayer insulating film between the upper and lower layers, and one or more driving circuit parts of one or more types may be disposed in each area. Through this, the efficiency of arranging driving circuit parts in a vertically stacked structure can be improved.

For example, a circuit part occupying a relatively large area or including a large number of circuits, such as the buffer circuit part, may be disposed across both upper and lower layers, while the remaining driving circuit parts may be disposed in either an upper or lower layer. For example, driving circuit parts that are related to each other in terms of their driving circuits can be disposed adjacent to or on the same layer, thereby facilitating precise control in circuit layout design.

Through this, the reduction effect on the peripheral area PA, facilitating the easy implementation of a high-density and high-resolution display apparatus 2000.

Meanwhile, in another embodiment, a driving circuit part area with a relatively large area or high signal processing requirements may include a thin-film transistor with an active layer different from those in other areas. The active layer may include oxide semiconductors with relatively higher electrical properties, particularly electron mobility, than those in other areas.

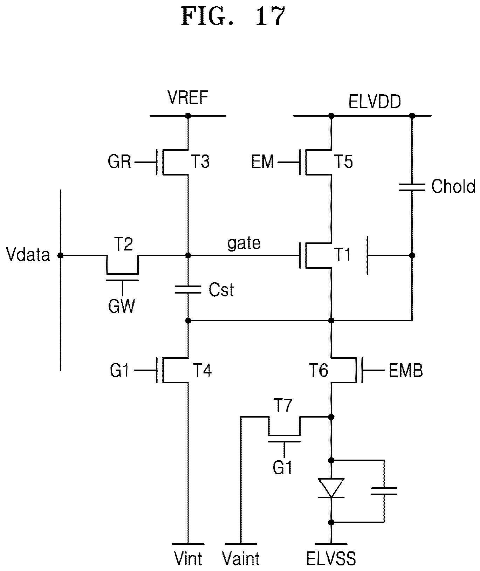

FIG. 17 is a schematic diagram of an equivalent circuit of one pixel of the display apparatus according to an embodiment of the disclosure.

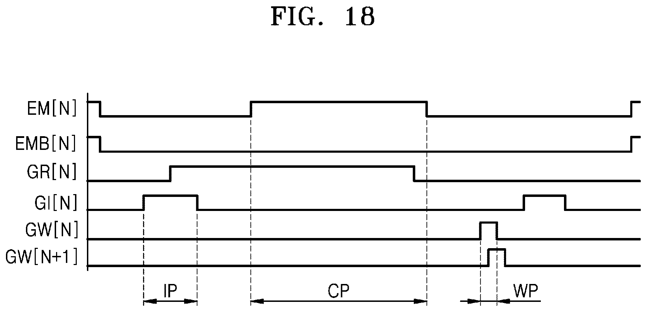

FIG. 18 is a schematic waveform diagram of driving signals for driving the pixel illustrated in FIG. 17.

In the embodiment, a pixel circuit may include, in another embodiment, seven pixel transistors (hereinafter, referred to as first to seventh pixel transistors T1 to T7) and three capacitors. However, this is just one example and may include a smaller number of transistors and capacitors.

Further, pixel transistors included in the pixel circuit may include the configurations of at least some or all of the aforementioned embodiments, and, for example, may include thin-film transistors with active layers including oxides. Thus, the detailed descriptions of the configurations of the thin-film transistors, such as the active layer, the gate electrode, and the connection electrode, will be omitted.

One gate of a first pixel transistor T1 may be electrically connected to a source of the first pixel transistor T1.

In the embodiment, for example, the first pixel transistor T1 may be a driving transistor. A second pixel transistor T2 may be referred to as a switching transistor.

An organic light-emitting element (see the embodiments described above) may have a first electrode connected to a first power supply voltage ELVSS.

The first pixel transistor T1 may be electrically connected to a power line that receives a second power supply voltage ELVDD. In another embodiment, the first pixel transistor T1 may include multiple gates, for example, an upper gate and a lower gate.

The second pixel transistor T2 may be electrically connected to a data line.

A third pixel transistor T3 may be electrically connected to a voltage line that receives a reference voltage VREF. The third pixel transistor T3 may connected to a reference scan line GR, and for example, a gate thereof may be electrically connected to the reference scan line GR.

A fourth pixel transistor T4 may be electrically connected to a voltage line that receives an initialization voltage Vint. The fourth pixel transistor T4 may be electrically connected to an initialization scan line, for example, a gate thereof may be electrically connected to the initialization scan line.

A fifth pixel transistor T5 may be electrically connected to the power line that receives the second power supply voltage ELVDD and may also be electrically connected to a light emission signal line, for example, a gate thereof may be electrically connected to the light emission signal line.

A sixth pixel transistor T6 may be electrically connected to the light-emitting element.

A seventh pixel transistor T7 may be electrically connected to a voltage line that receives an initialization voltage Vaint. As an example of the disclosure, the initialization voltage Vaint may have a different level from the initialization voltage Vint.

Referring to FIGS. 17 and 18, during an initialization period IP, one pixel transistor (e.g., the fourth pixel transistor) may be turned on, and the first electrode of the light-emitting element may be initialized to the initialization voltage through the turned-on fourth pixel transistor. At this time, one capacitor may be initialized to a difference value between the first power supply voltage ELVSS and the initialization voltage Vint.

Thereafter, during a light emission period, the sixth pixel transistor T6 may be turned on simultaneously with the fifth pixel transistor T5. A current output through the first pixel transistor T1 may be provided to the light-emitting element through the turned-on sixth pixel transistor T6.

In more detail, the display apparatus displays an image during each frame period. Each of write scan lines, reference scan lines, initialization scan lines, and light emission signal lines sequentially receives scan signals or light emission control signals during the frame period. FIG. 18 may illustrate a portion of the frame period. Each of the scan signals or light emission control signals EM, EMB, GR, GW, and GI may have a high voltage (or a high level) V-HIGH during a certain period and a low voltage (or low level) V-LOW during another period. For example, the first to fifth N-type pixel transistors T1 to T5 may be turned on in case that the corresponding scan signals have the high voltage V-HIGH.

During the initialization period IP, the third pixel transistor T3 and the fourth pixel transistor T4 may be turned on. During the initialization period IP, an initialization process may be performed with the reference voltage VREF or the initialization voltage Vint. A capacitor Cst between the third pixel transistor T3 and the fourth pixel transistor T4 is initialized to a difference value between the reference voltage VREF and the initialization voltage Vint. Another capacitor Chold is initialized to a difference value between the second power supply voltage ELVDD and the initialization voltage Vint.

During a compensation period CP, the third pixel transistor T3 and the fifth pixel transistor T5 may be turned on. A threshold voltage of the first pixel transistor T1 may be compensated by capacitor coupling.

During a write period WP, the second pixel transistor T2 may be turned on. The second pixel transistor T2 outputs a voltage corresponding to a data signal. As a result, the capacitor is charged with a voltage value corresponding to the data signal. In addition, regardless of the deviation in the threshold voltages of the first pixel transistors T1 of the pixels, a current proportional to the data signal may be supplied to the light-emitting element.

Thereafter, during the light emission period, the fifth pixel transistor T5 may be turned on and the first pixel transistor T1 provides a current corresponding to the voltage value stored in the capacitor to the light-emitting element, and the light-emitting element may emit light with a brightness corresponding to the data signal.

In the embodiment, the circuit included in one pixel may include seven transistors. These seven pixel transistors may include at least one of the first thin-film transistor and the second thin-film transistor of one of the above-described embodiments. For example, the thin-film transistors each including an active layer including an oxide may be disposed on different layers in the thickness direction of the substrate, for example, on the lower layer and the upper layer with the interlayer insulating film therebetween.

For example, the first pixel transistor T1 and the second pixel transistor T2 may include or correspond (or directly correspond) to the first thin-film transistor and the second thin-film transistor in the above-described embodiments, respectively.

As another example, all seven pixel transistors, each including a thin-film transistor including an oxide, may be disposed such that multiple transistors are disposed on each of the lower and upper layers, with an interlayer insulating film interposed between the lower and upper layers in the thickness direction of the substrate. For example, two to five pixel transistors may be disposed on the lower layer and five to two pixel transistors may be disposed on the upper layer.

Through this arrangement, high integration of the circuit within a single pixel may be facilitated.

The driving circuit part configured to control or generate signals for driving pixels may be disposed in the non-display area. For example, the driving circuit part for generating or controlling one or more light emission control signals EM and EMB and one or more scan control signals GR, GI, GR, and GW may be disposed in the non-display area. These driving circuit parts may be disposed on the upper and lower layers of the substrate with the interlayer insulating film interposed between the upper and lower layers. For example, the driving circuit parts may be disposed using the configurations illustrated in FIGS. 10 to 16 from the above-described embodiments. This allows for the reduction of the non-display area or bezel of the display apparatus, thereby facilitating the implementation of high integration and high resolution.

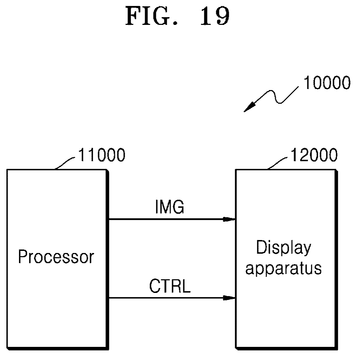

FIG. 19 is a schematic block diagram illustrating a display system according to an embodiment of the disclosure.

Referring to FIG. 19, the display system 10000 may include a processor 11000 and a display apparatus 12000.

The processor 11000 may perform various tasks and calculations. The processor 11000 may include an application processor, a graphics processor, a microprocessor, a central processing unit (CPU), and the like. The processor 11000 may be electrically connected to other components of the display system 10000 through a bus system to control the other components.

The processor 11000 may transmit image data IMG and a control signal CTRL to the display apparatus 12000. The display apparatus 12000 may display an image based on the image data IMG and the control signal CTRL. The display apparatus 12000 may be similarly configured to the display apparatus 100 described with reference to FIG. 1.
The display system 10000 may include a computing system providing an image display function, such as a smart watch, a mobile phone, a smart phone, a portable computer, a tablet personal computer (PC), a watch phone, an automotive display, smart glasses, a portable multimedia player (PMP), a navigation device, and an ultra mobile personal computer (UMPC). The display system 10000 may include at least one of a head mounted display (HMD) device, a virtual reality (VR) device, a mixed reality (MR) device, and an augmented reality (AR) device.

Although the disclosure has been described with reference to embodiments described with reference to the drawings, these are merely examples, and those skilled in the art will understand that various modifications and variations of the embodiments are possible therefrom. Therefore, the true technical scope of protection of the disclosure should be determined by the technical idea of the appended claims.

In a display apparatus of the embodiments of the disclosure, high-resolution and high image quality characteristics can be readily implemented.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus (100) comprising:
a substrate (101);
a first thin-film transistor (110); and
a second thin-film transistor (120),
wherein the first thin-film transistor (110) includes a first active layer (113) including an oxide and is disposed above the substrate (101),
the second thin-film transistor (120) includes a second active layer (123) including an oxide and is disposed above the substrate (101), and
the first thin-film transistor (110) is disposed between the substrate (101) and the second thin-film transistor (120) in a thickness direction (Z) of the substrate (101) such that a distance between the substrate (101) and the first thin-film transistor (110) has a smaller value than a distance between the substrate (101) and the second thin-film transistor (120).

2. The display apparatus (100) of claim 1, further comprising:
one or more interlayer insulating layers (ILD1, ILD2) disposed between the first thin-film transistor (110) and the second thin-film transistor (120).

3. The display apparatus (100) of claim 1 or claim 2, wherein the first thin-film transistor (110) and the second thin-film transistor (120) overlap in at least an area in the thickness direction (Z) of the substrate (101), and
the first active layer (113) of the first thin-film transistor (110) and the second active layer (123) of the second thin-film transistor (120) overlap in at least an area in the thickness direction (Z) of the substrate (101).

4. The display apparatus (100) of any preceding claim, wherein the first active layer (113) of the first thin-film transistor (110) and the second active layer (123) of the second thin-film transistor (120) have different properties.

5. The display apparatus (100) of any preceding claim, further comprising:
a conductive pattern portion (BML1, BML2) overlapping the first active layer (113) of the first thin-film transistor (110) or the second active layer (123) of the second thin-film transistor (120).

6. The display apparatus (100) of claim 5, wherein the conductive pattern portion (BML1, BML2) is electrically connected to an area of the first thin-film transistor (110) or an area of the second thin-film transistor (120) through one or more contact holes,
optionally wherein:
(i) the first thin-film transistor (110) includes one or more connection electrodes (116, 117) electrically connected to the first active layer (113), or the second thin-film transistor (110) comprises one or more connection electrodes (126, 127) electrically connected to the first active layer (113), and
(ii) the conductive pattern portion (BML1, BML2) is electrically connected to at least an area of the one or more connection electrodes (116, 117, 126, 127).

7. The display apparatus (100) of any preceding claim, further comprising:
an intermediate conductive layer (BBM) disposed between the first thin-film transistor (110) and the second thin-film transistor (120),
optionally wherein the intermediate conductive layer (BBM) is formed to correspond to at least a width of the first active layer (113) or the second active layer (123) in one direction.

8. The display apparatus (100) of claim 7, wherein, through an area in which the intermediate conductive layer (BBM) is not present, the first thin-film transistor (110) or one or more conductive patterns (116, 117) disposed at a same layer as or a different layer from the first thin-film transistor (110) is electrically connected to the second thin-film transistor (120) or one or more conductive patterns (126, 127) disposed at a same layer as or a different layer from the second thin-film transistor (120).

9. The display apparatus (100) of any preceding claim, further comprising;
a display area (DA) and a peripheral area (PA) disposed on at least one side of the display area (DA) on the substrate (101),
wherein one or more pixels are disposed in the display area (DA), and
a driving circuit part area which generates or controls one or more signals for operations of the one or more pixels is disposed in the peripheral area (PA).

10. The display apparatus (100) of claim 9, wherein the first thin-film transistor (110) and the second thin-film transistor (120) are disposed to correspond to one pixel among the one or more pixels.

11. The display apparatus (100) of claim 10, wherein
in the one pixel,
one or more thin-film transistors (930), each including an active layer (933) including an oxide and configured for driving the one pixel, are disposed adjacent to the first thin-film transistor (110), and
one or more thin-film transistors (940), each including an active layer (943) including an oxide and configured for driving the one pixel, are disposed adjacent to the second thin-film transistor (120),
optionally wherein:
(i) the first thin-film transistor (110) and the one or more thin-film transistors (930) adjacent thereto are disposed at a same layer, and
(ii) the second thin-film transistor (120) and the one or more thin-film transistors (940) adjacent thereto are disposed at a same layer.

12. The display apparatus (100) of any of claims 9-11, wherein the first thin-film transistor (110) and the second thin-film transistor (120) are disposed to correspond to the driving circuit part area,
optionally wherein the first thin-film transistor (110)_and the second thin-film transistor (120) respectively correspond to two driving circuit parts (BFR, ELG) of different types disposed in the driving circuit part area.

13. The display apparatus (100) of claim 12, wherein
in the driving circuit part area, a plurality of driving circuit parts (BFR, ELG) are disposed on each of an upper layer and a lower layer, with an interlayer insulating film (ILD) in between,
a plurality of thin-film transistors (930) each including an active layer (933) including an oxide are disposed at a same layer as the first thin-film transistor (110) to be disposed adjacent to the first thin-film transistor (110),
a plurality of thin-film transistors (940) each including an active layer (943) including an oxide are disposed at a same layer as the second thin-film transistor (120) to be disposed adjacent to the second thin-film transistor (120), and
the plurality of thin-film transistors (930, 940) are disposed to correspond respectively to the plurality of driving circuit parts (BFR, ELG),
optionally wherein driving circuits (BFR, ELG) disposed in the upper and lower layers, with the interlayer insulating film (ILD) in between, are of different types.

14. An electronic device comprising:
a display apparatus (100),
wherein the display apparatus (100) includes:
a substrate (101);
a first thin-film transistor (110); and
a second thin-film transistor (120),
the first thin-film transistor (110) includes a first active layer (113) including an oxide and is disposed above the substrate (101),
the second thin-film transistor (120) includes a second active layer (123) including an oxide and is disposed above the substrate (101), and
the first thin-film transistor (110) is disposed between the substrate (101) and the second thin-film transistor (120) in a thickness direction (Z) of the substrate (101) such that a distance between the substrate (101) and the first thin-film transistor (110) has a smaller value than a distance between the substrate (101) and the second thin-film transistor (120).

15. The electronic device of claim 14, further comprising:
one or more interlayer insulating layers (ILD1, ILD2) disposed between the first thin-film transistor (110) and the second thin-film transistor (120).
